(19) Europäisches Patentamt
European Patent Office
Office européen des brevets

(11) **EP 2 955 849 A1**

(12) **EUROPÄISCHE PATENTANMELDUNG**

(43) Veröffentlichungstag:
16.12.2015 Patentblatt 2015/51

(51) Int Cl.:
*H03K 17/16* (2006.01)     *H03K 17/082* (2006.01)

(21) Anmeldenummer: 14172012.8

(22) Anmeldetag: 11.06.2014

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **CT-Concept Technologie GmbH**
**2504 Biel-Bienne (CH)**

(72) Erfinder: **Rätz, Markus**
**3297 Leuzigen (CH)**

(74) Vertreter: **Conroy, John et al**
**Fish & Richardson P.C.**
**Highlight Business Towers**
**Mies-van-der-Rohe-Straße 8**
**80807 München (DE)**

(54) **Vorrichtung zum Erzeugen eines dynamischen Referenzsignals für eine Treiberschaltung für einen Halbleiter-Leistungsschalter**

(57)     Eine Vorrichtung (442) zum Erzeugen eines dynamischen Referenzsignals ($U_{REF}$) für eine Steuerschaltung für einen Leistungshalbleiterschalter umfasst einen Referenzsignal-Generator (442) zur Bereitstellung eines dynamischen Referenzsignals ($U_{REF}$), das nach Verstreichen einer vorbestimmten Zeit nach einem Umschaltvorgang des Leistungshalbleiterschalter einen stationären Signalpegel hat, eine passive Lade-Schaltung (450), die ausgelegt ist, um einen Signalpegel des dynamischen Referenzsignals in Reaktion auf ein Umschalten eines Steuersignals des Leistungshalbleiterschalters von einem AUS-Zustand in einen AN-Zustand für mindestens einen Teil der vorbestimmten Zeit über den stationären Signalpegel zu erhöhen zur Erzeugung des dynamischen Referenzsignals und einen Ausgang (A) zum Abgreifen des dynamischen Referenzsignals ($U_{REF}$).

FIG. 4A

EP 2 955 849 A1

**Beschreibung**

**Technisches Gebiet**

Die vorliegende Erfindung betrifft eine Vorrichtung und ein Verfahren zum Erzeugen eines variablen Referenzsignals für eine Treiberschaltung für einen Halbleiter-Leistungsschalter. Derartige Vorrichtungen werden beispielsweise zum Detektieren eines Kurzschluss- oder Überstromzustands in einem IGBT ("Insulated Gate Bipolar Transistor") verwendet.

**Hintergrund**

In manchen Leistungshalbleiterschaltern können hohe Spannungen angelegt und hohe Ströme geführt werden. Kurzschlüsse oder überhöhte Ströme können daher schnell zur thermischen Zerstörung der Leistungshalbleiterschalter führen. Daher können Leistungshalbleiterschalter Schutzschaltungen zur Detektion eines Kurzschluss- oder Überstromzustands aufweisen. Eine Möglichkeit, diese Zustände zu detektieren, ist die indirekte Überwachung des Stroms durch den Leistungshalbleiterschalter anhand einer über dem Leistungshalbleiterschalter abfallenden Spannung. Diese sollte nach Einschalten des Leistungshalbleiterschalters zügig von einem relativ hohen Pegel im ausgeschalteten Zustand (der "ausgeschaltete Zustand" oder "AUS-Zustand" ist ein Zustand des Leistungshalbleiterschalter, in dem dieser "offen" ist und keinen Strom führt) auf einen relativ niedrigen Pegel im angeschalteten Zustand fallen (der "angeschaltete Zustand" oder "AN-Zustand" ist ein Zustand des Leistungshalbleiterschalter, in dem dieser "geschlossen" ist und Strom führen kann). Entsprechend hat ein Steuersignal eines Leistungshalbleiterschalters (zum Beispiel ein Gate-Emitter-Treibersignal) einen AN-Zustand, in dem es den Leistungshalbleiterschalter geschlossen hält und einen AUS-Zustand, in dem es den Leistungshalbleiterschalter offen hält.

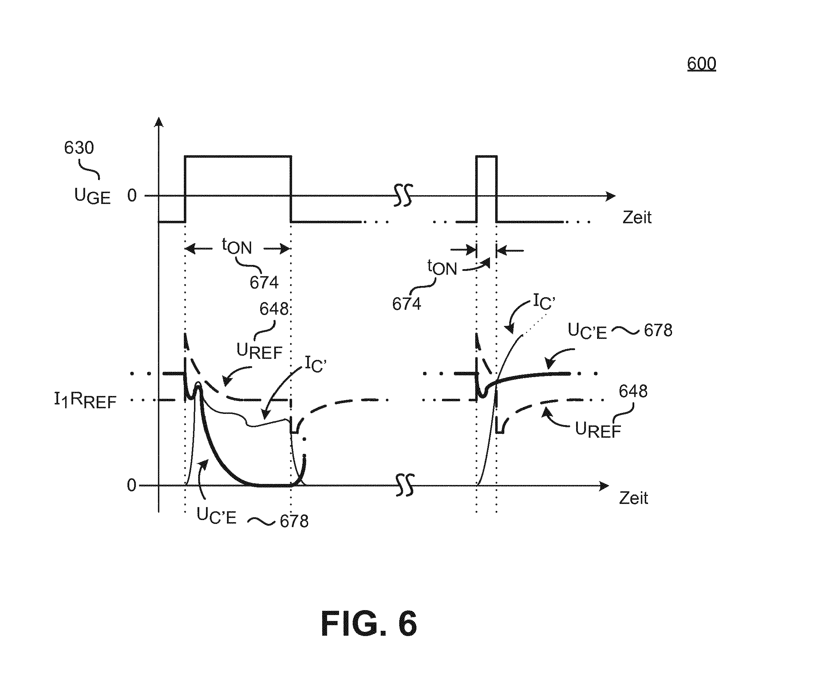

Die durchgezogene Kurve 678 links unten in Figur 6 zeigt einen beispielhaften Verlauf einer Kollektor-Emitter-Spannung eines IGBT (ein IGBT ist ein beispielhafter Leistungshalbleiteschalter) während dem Umschaltvorgang von einem ausgeschalteten Zustand in einen angeschalteten Zustand (der Verlauf eines zugehörigen beispielhaften Steuersignal 630 ist links oben dargestellt). Wie dargestellt fällt die Kollektor-Emitter-Spannung stark auf einen sehr geringen Wert ab (nahe bei 0 Volt). Ein beispielhaftes Kurzschlussverhalten eines IGBT ist rechts unten in Figur 6 dargestellt (durchgezogene Kurve 678). Im Gegensatz zum Normalbetrieb fällt die Kollektor-Emitter-Spannung nicht auf den sehr geringen Wert ab, gleichzeitig können aber in dem IGBT hohe Ströme fließen (zum Beispiel zwischen dem dreifachen und zehnfachen Nennstrom des IGBT). In anderen Kurzschlussfällen sinkt die Kollektor-Emitter-Spannung zwar zunächst auf den Wert im Normalbetrieb ab, steigt aber dann wieder an. Daraus resultiert eine hohe thermische Belastung des Leistungshalbleiterschalters, der nach relativ kurzer Zeit Schaden nehmen kann. So überstehen zum Beispiel einige IGBTs im angeschalteten Zustand einen Kurzschluss für etwa 10 $\mu s$, ohne Schaden zu nehmen. Daher können die Schutzschaltungen zur Detektion eines Kurzschluss- oder Überstromzustands in diesem Zeitbereich dafür sorgen, dass der Leistungshalbleiterschalter abgeschaltet wird. Ähnliche Charakteristiken sind auch in anderen Leistungshalbleiterschalter außer IGBTs zu finden. Ein Überstromzustand kann sich wie ein Kurzschlusszustand durch eine erhöhte Kollektor-Emitter-Spannung zeigen. Allerdings kann im Überstromfall die Kollektor-Emitter-Spannung näher an einer Kol-lektor-Emitter-Spannung im Normalfall liegen als im Kurzschlussfall.

Die geschilderten Unterschiede im Verlauf der Kollektor-Emitter-Spannung zwischen Normalbetrieb und Kurzschluss- und/oder Überstromfall kann in Schutzschaltungen zur Detektion eines Kurzschluss- oder Überstromzustands ausgenutzt werden, um einen Kurzschluss- oder Überstromzustand zu detektieren. So ist es möglich, einen Schwellwert für die Kollektor-Emitter-Spannung zu definieren, der verwendet wird, um das Vorliegen eines Kurzschluss- oder Überstromzustands zu detektieren. Zum Beispiel kann, wenn die Kollektor-Emitter-Spannung über den Schwellwert steigt (siehe Figur 6 rechts unten) ein Kurzschluss- oder Überstromzustand detektiert werden.

**Zusammenfassung der Erfindung**

Eine erste Vorrichtung zum Erzeugen eines dynamischen Referenzsignals für eine Steuerschaltung für einen Leistungshalbleiterschalter gemäß einer Ausführungsform der Erfindung umfasst einen Referenzsignal-Generator zur Bereitstellung eines dynamischen Referenzsignals, das nach Verstreichen einer vorbestimmten Zeit nach einem Umschaltvorgang des Leistungshalbleiterschalter einen stationären Signalpegel hat, eine passive Lade-Schaltung, die ausgelegt ist, um einen Signalpegel des dynamischen Referenzsignals in Reaktion auf ein Umschalten eines Steuersignals des Leistungshalbleiterschalters von einem AUS-Zustand in einen AN-Zustand für mindestens einen Teil der vorbestimmten Zeit über den stationären Signalpegel zu erhöhen zur Erzeugung des dynamischen Referenzsignals und einen Ausgang zum Abgreifen des dynamischen Referenzsignals.

Mit einer derartigen Vorrichtung ist es möglich, einen Kurzschluss- und/oder Überstromzustand in einem Leistungshalbleiterschalter zuverlässig und auch schnell genug zu detektieren. Insbesondere kann die Wahrscheinlichkeit der fälschlichen Detektion eines Kurzschluss- und/oder Überstromzustand im Vergleich zu Vorrichtungen mit einem stationären Referenzsignal verringert werden. Dieses wird durch das kurzzeitige Erhöhen des Pegels des Referenzsignals für mindestens einen Teil einer vorbestimmten Zeit in Reaktion auf ein Umschalten eines Steuersignals des Leistungshalbleiterschalters von einem AUS-Zustand in einen AN-Zustand erreicht. Gleichzeitig kann die Vorrichtung der Erfindung die Erhöhung des Pegels des dynamischen Referenzsignals ohne aktive Bauelemente bewerkstelligen. Damit kann die Vorrichtung kostengünstiger und robuster sein als vergleichbare Vorrichtungen mit aktiven Bauelementen. In einigen Beispielen kann die Vorrichtung mit verhältnismässig geringem Aufwand zuverlässig und mit einer vernachlässigbar geringen Temperaturdrift ausgelegt werden.

Ein beispielhafter Verlauf eines dynamischen Referenzsignals ist in Figur 6 links unten gezeigt (gestrichelte Linie 648). Der Pegel des dynamischen Referenzsignals wird in Reaktion auf ein Umschalten eines Steuersignals des Leistungshalbleiterschalters von einem AUS-Zustand in einen AN-Zustand sprunghaft erhöht und fällt daraufhin kontinuierlich ab, bis der stationäre Pegel wieder erreicht wird. Diese erhöhte Referenzspannung in Anschluss an einen Umschaltvorgang von einem Aus- in einen AN-Zustand kann in einer Schutzschaltung verwendet werden. Die Schutzschaltung löst nicht aus, da ein Kollektor-Emitter-Spannung repräsentierendes Signal ($U_{C'E}$) immer unterhalb des Referenzsignals bleibt.

In einer zweiten Vorrichtung gemäß der ersten Vorrichtung ist das dynamische Referenzsignal eine dynamische Referenzspannung.

In einer dritten Vorrichtung gemäß der ersten oder zweiten Vorrichtung ist der Leistungshalbleiterschalter ein IGBT.

In einer vierten Vorrichtung gemäß einer der vorangehenden Vorrichtungen umfasst die passive Lade-Schaltung ein RC-Glied.

In einer fünften Vorrichtung gemäß der vierten Vorrichtung ist die passive Lade-Schaltung ausgelegt, so dass das Steuersignal des Leistungshalbleiterschalters an einen ersten Anschluss einer Kapazität des RC-Gliedes gekoppelt werden kann und ein zweiter Anschluss der Kapazität des RC-Gliedes direkt oder indirekt an den Ausgang zum Abgreifen des dynamischen Referenzsignals gekoppelt ist.

In einer sechsten Vorrichtung gemäß einer der vorangehenden Vorrichtungen ist die passive Lade-Schaltung dazu ausgelegt, den Signalpegel des dynamischen Referenzsignals in Reaktion auf das Umschalten des Steuersignals sprungförmig zu erhöhen.

In einer siebten Vorrichtung gemäß der fünften oder sechsten Vorrichtung ist die passive Lade-Schaltung weiter ausgelegt, so dass sich die Kapazität des RC-Gliedes im Anschluss an ein Umschalten eines Steuersignals des Leistungshalbleiterschalters von einem AN-Zustand in einen AUS-Zustand lädt.

In einer achten Vorrichtung gemäß der vierten oder der vierten und einer der fünften bis siebten Vorrichtungen ist die passive Lade-Schaltung so ausgelegt, dass sich die Kapazität des RC-Gliedes im Anschluss an das Umschalten des Steuersignals entlädt und damit den zweitweise erhöhten Pegel des dynamischen Referenzsignals erzeugt und durch die Entladung wieder auf den stationären Pegel zurückzuführt.

In einer neunten Vorrichtung gemäß der achten Vorrichtung ist eine 1/e Zeitkonstante des RC-Glieds größer als 1 $\mu$s.

In einer zehnten Vorrichtung gemäß der achten Vorrichtung liegt eine 1/e Zeitkonstante des RC-Glieds zwischen 5 und 15 $\mu$s.

In einer elften Vorrichtung gemäß einer der vorangehenden Vorrichtungen enthält der Referenzsignal-Generator eine Schaltung zum Erzeugen des stationären Signalpegels.

In einer zwölften Vorrichtung gemäß der elften Vorrichtung umfasst die Schaltung zum Erzeugen des stationären Signalpegels ein oder mehr Widerstände und einen Eingang zum Empfangen eines Konstantstroms, wobei die Schaltung zum Erzeugen des stationären Signalpegels konfiguriert ist, den Konstantstrom durch die ein oder mehr Widerstände zu leiten, so dass über den ein oder mehr Widerständen ein eine stationäre Referenzspannung abfällt, um den stationären Signalpegel zu erzeugen.

In einer dreizehnten Vorrichtung gemäß der zwölften Vorrichtung sind die ein oder mehr Widerstände an einen ersten internen Referenzpegel gekoppelt.

In einer vierzehnten Vorrichtung gemäß der dreizehnten Vorrichtung wobei der erste interne Referenzpegel einer Emitterspannung, einer Kathodenspannung oder einer Sourcespannung des Leistungshalbleiterschalters entspricht.

In einer fünfzehnten Vorrichtung gemäß einer der vorangehenden Vorrichtungen umfasst die Vorrichtung weiter eine erste Klemmschaltung, die dazu ausgelegt ist, die dynamische Referenzspannung auf einen vorbestimmten Minimalpegel zu begrenzen.

In einer sechzehnten Vorrichtung gemäß der fünfzehnten Vorrichtung entspricht der Minimalpegel einer Emitterspannung, einer Kathodenspannung oder einer Sourcespannung des Leistungshalbleiterschalters.

In einer siebzehnten Vorrichtung gemäß der fünfzehnten Vorrichtung ist der Minimalpegel kleiner oder gleich dem stationären Signalpegels.

In einer achtzehnten Vorrichtung gemäß einer der vorangehenden Vorrichtungen umfasst die Vorrichtung weiter eine zweite Klemmschaltung, die dazu ausgelegt ist, die dynamische Referenzspannung auf einen vorbestimmten Maximalpegel zu beschränken.

In einer neunzehnten Vorrichtung gemäß der achtzehnten Vorrichtung entspricht der Maximalpegel einem Signalpegel des Steuersignals im AN-Zustand.

In einer zwanzigsten Vorrichtung gemäß einer der vorangehenden Vorrichtungen umfasst die Vorrichtung weiter einen passiven Schalter, der zwischen den Referenzsignal-Generator und die passive Lade-Schaltung gekoppelt ist, wobei der passive Schalter dazu ausgelegt ist, den Referenzsignal-Generator und die passive Lade-Schaltung zu trennen in Reaktion auf ein Umschalten des Steuersignals des Leistungshalbleiterschalters von einem AN-Zustand in einen AUS-Zustand.

In einer einundzwanzigsten Vorrichtung gemäß einer der vorangehenden Vorrichtungen liegt die vorbestimmte Zeit zwischen 4 und 25 $\mu$s.

In einer zweizwanzigsten Vorrichtung gemäß einer der vorangehenden Vorrichtungen liegt die vorbestimmte Zeit zwischen 8 und 15 $\mu$s.

In einer dreiundzwanzigsten Vorrichtung gemäß einer der vorangehenden Vorrichtungen ist die passive Lade-Schaltung ausgelegt, um einen Signalpegel des dynamischen Referenzsignals in Reaktion auf ein Umschalten eines Steuersignals des Leistungshalbleiterschalters von einem AUS-Zustand in einen AN-Zustand für die gesamte vorbestimmte Zeit über den stationären Signalpegel zu erhöhen zur Erzeugung des dynamischen Referenzsignals.

In einer vierundzwanzigsten Vorrichtung gemäß einer der vorangehenden Vorrichtungen ist das dynamische Referenzsignal ein Spannungssignal.

In einer fünfundzwanzigsten Vorrichtung gemäß einer der ersten bis dreiundzwanzigsten Vorrichtungen ist das dynamische Referenzsignal ein Stromsignal.

In einer fünfundzwanzigsten Vorrichtung gemäß der elften Vorrichtung oder der elften Vorrichtung und einer der vorangehenden Vorrichtungen umfasst die Schaltung zum Erzeugen des stationären Signalpegels einen Eingang zum Empfangen einer Konstantspannung.

In einer sechsundzwanzigsten Vorrichtung gemäß einer der vorangehenden Vorrichtungen bildet ein interner Referenzpegel der Vorrichtung den stationären Signalpegel.

Eine erste Steuerschaltung für einen Leistungshalbleiterschalter gemäß einem Beispiel der Erfindung umfasst eine Vorrichtung zum Erzeugen eines dynamischen Referenzsignals für eine Steuerschaltung für einen Leistungshalbleiterschalter gemäß einem der ersten bis sechsundzwanzigsten Vorrichtungen, eine Kurzschluss- und/oder Überstromzustand-Detektionsschaltung, die ein dynamische Referenzsignal von der Vorrichtung zum Erzeugen eines dynamischen Referenzsignals und ein Signal, das für eine Kollektor-Emitter-Spannung repräsentativ ist, ein Signal, das für eine Anoden-Kathoden-Spannung repräsentativ ist oder ein Signal, das für eine Drain-Source-Spannung des Leistungshalbleiterschalters repräsentativ ist empfängt und ausgelegt ist, das dynamische Referenzsignal mit dem Signal, das für eine Kollektor-Emitter-Spannung, für eine Anoden-Kathoden-Spannung oder für eine Drain-Source-Spannung repräsentativ ist zu vergleichen, um ein Fehlersignal zu erzeugen ein Vorliegen eines Kurzschluss- und/oder Überstromzustands in dem Leistungshalbleiterschalter anzeigt und eine Treiberschaltung, die das Fehlersignal empfängt und dazu ausgelegt ist, den Leistungshalbleiterschalter auszuschalten, wenn das Fehlersignal das Vorliegen eines Kurzschluss- und/oder Überstromzustands in dem Leistungshalbleiterschalter anzeigt.

In einer zweiten Steuerschaltung gemäß der ersten Steuerschaltung zeigt die Kurzschluss- und/oder Überstromzustand-Detektionsschaltung das Vorliegen eines Kurzschluss- und/oder Überstromzustands in dem Leistungshalbleiterschalter an, wenn das Signal, das für eine Kollektor-Emitter-Spannung, für eine Anoden-Kathoden-Spannung oder für eine Drain-Source-Spannung repräsentativ größer ist als das dynamische Referenzsignal In einer dritten Steuerschaltung gemäß der ersten oder zweiten Steuerschaltung und der einer der elften bis dreizehnten Vorrichtungen umfasst die Treiberschaltung weiter die Stromquelle zum Erzeugen des Konstantstroms.

Eine erste Vorrichtung zum Bereitstellen von elektrischer Energie umfasst ein oder mehrere Eingänge zum Anschluss an eine Quelle elektrischer Energie, ein oder mehrere Ausgänge zum Anschluss eines oder mehrerer Verbraucher, eine der ersten bis dritten Steuerschaltungen und einen Leistungshalbleiterschalter, der durch die Steuerschaltung gesteuert wird, wobei die Vorrichtung dazu ausgelegt ist, elektrische Energie durch Steuerung des Leistungshalbleiterschalters von den ein oder mehreren Eingänge zu den ein oder mehreren Ausgängen zu übertragen.

In einer zweiten Vorrichtung zum Bereitstellen von elektrischer Energie gemäß der ersten Vorrichtung zum Bereitstellen von elektrischer Energie ist der Leistungshalbleiterschalter ein IGBT oder ein rückwärtssperrender IGBT. In einer dritten Vorrichtung zum Bereitstellen von elektrischer Energie gemäß der ersten Vorrichtung zum Bereitstellen von elektrischer Energie ist der Leistungshalbleiterschalter ein GTO, ein IEGT, ein MOSFET oder ein Bipolartransistor.

In einer vierten Vorrichtung zum Bereitstellen von elektrischer Energie gemäß einer der ersten bis dritten Vorrichtungen zum Bereitstellen von elektrischer Energie und der vierten Vorrichtung entlädt sich die Kapazität des RC-Gliedes mit einer Zeitkonstante, die ausgewählt ist, um zu verhindern, dass die Kurzschluss- und/oder Überstromzustand-Detektionsschaltung im Normalbetrieb einen Kurzschluss- und/oder Überstromzustand detektiert. In einer fünften Vorrichtung zum Bereitstellen von elektrischer Energie gemäß einer der ersten bis vierten Vorrichtungen zum Bereitstellen von elektrischer Energie und der vierten Vorrichtung entlädt sich die Kapazität des RC-Gliedes mit einer Zeitkonstante entlädt, die ausgewählt ist, um sicherzustellen, dass die Kurzschluss- und/oder Überstromzustand-Detektionsschaltung im Kurzschluss- und/oder Überstromfall einen Kurzschluss- und/oder Überstromzustand detektiert.

In einer sechsten Vorrichtung zum Bereitstellen von elektrischer Energie gemäß einer der ersten bis fünften Vorrichtungen zum Bereitstellen von elektrischer Energie umfasst die Steuerschaltung weiter einen zweiten Leistungshalbleiterschalter, eine zweite Steuerschaltung für den zweiten Leistungshalbleiterschalter, wobei die zweite Steuerungsschaltung eine zweite Vorrichtung zum Erzeugen eines dynamischen Referenzsignals für eine Steuerschaltung für den zweiten Leistungshalbleiterschalter gemäß einem der Vorrichtungen 1 bis 25 umfasst, eine zweite Kurzschluss- und/oder Überstromzustand-Detektionsschaltung, die ein dynamische Referenzsignal von der zweiten Vorrichtung zum Erzeugen eines dynamischen Referenzsignals und ein Signal, das für eine Kollektor-Emitter-Spannung repräsentativ ist, oder ein Signal, das für eine Kollektor-Emitter-Spannung, für eine Anoden-Kathoden-Spannung oder für eine Drain-Source-Spannung des Leistungshalbleiterschalters repräsentativ ist empfängt und ausgelegt ist, das dynamische Referenzsignal mit dem Signal, das für eine Kollektor-Emitter-Spannung, für eine Anoden-Kathoden-Spannung oder eine für eine Drain-Source-Spannung repräsentativ ist zu vergleichen, um ein zweites Fehlersignal zu erzeugen ein Vorliegen eines Kurzschluss- und/oder Überstromzustands in dem zweiten Leistungshalbleiterschalter anzeigt und eine zweite Treiberschaltung, die das zweite Fehlersignal empfängt und dazu ausgelegt ist, den zweiten Leistungshalbleiterschalter auszuschalten, wenn das Fehlersignal das Vorliegen eines Kurzschluss- und/oder Überstromzustands in dem Leistungshalbleiterschalter anzeigt.

In einer siebten Vorrichtung zum Bereitstellen von elektrischer Energie gemäß der sechsten Vorrichtung zum Bereitstellen von elektrischer Energie sind der erste und der zweite Leistungshalbleiterschalter in Serie geschaltet sind und die Vorrichtung dazu ausgelegt ist, dass eine Last zwischen den ersten und der zweiten Leistungshalbleiterschaltern gekoppelt wird und eine Eingangsspannung über den in Serie geschalteten ersten und der zweiten Leistungshalbleiterschaltern angelegt wird.

In einer achten Vorrichtung zum Bereitstellen von elektrischer Energie gemäß der siebten Vorrichtung zum Bereitstellen von elektrischer Energie sind die ersten und der zweite Leistungshalbleiterschalter dazu ausgelegt, eine Spannung zwischen 100 V und 15 kV zu tragen.

Ein Verfahren zum Erzeugen eines dynamischen Referenzsignals für einen Leistungshalbleiterschalter gemäß einem Beispiel der Erfindung, wobei die Verfahren umfasst das Erzeugen eines stationären Referenzsignals, das Empfangen eines Steuersignals des Leistungshalbleiterschalters, das Erhöhen eines Pegels des stationären Referenzsignals in Reaktion auf ein Umschalten eines Steuersignals des Leistungshalbleiterschalters von einem AUS-Zustand in einen AN-Zustand für mindestens einen Teil der vorbestimmten Zeit unter Verwendung einer passiven Schaltung und das Ausgeben dynamischen Referenzsignals.

## Kurzbeschreibung der Figuren

Nicht-limitierende und nicht-erschöpfende Ausführungsbeispiele der Erfindung sind bezugnehmend auf die folgenden Figuren beschrieben, wobei gleiche Referenzzeichen sich auf gleiche Komponenten in den verschiedenen Figuren beziehen, soweit nichts Anderes spezifiziert ist.

**Fig. 1** zeigt eine Vorrichtung zur Bereitstellung von elektrischer Energie an eine Last.
**Fig. 2** stellt eine beispielhafte Steuerschaltung dar.
**Fig. 3** zeigt eine beispielhafte Vorrichtung zum Erzeugen eines dynamischen Referenzsignals.
**Fig. 4A** zeigt ein Beispiel einer Vorrichtung zum Erzeugen eines dynamischen Referenzsignals.
**Fig. 4B** zeigt ein weiteres Beispiel einer Vorrichtung zum Erzeugen eines dynamischen Referenzsignals.
**Fig. 5A** zeigt verschiedene Signale in der Vorrichtung zum Erzeugen eines dynamischen Referenzsignals aus Fig. 4A.
**Fig. 5B** zeigt verschiedene Signale in der Vorrichtung zum Erzeugen eines dynamischen Referenzsignals aus Fig. 4B.
**Fig. 6** zeigt verschiedene Signale zur Bereitstellung von elektrischer Energie an eine Last aus Fig. 1 in einem Normalzustand und in einem Kurzschluss- und/oder Überstromzustand.
**Fig. 7** zeigt ein weiteres Beispiel einer Vorrichtung zum Erzeugen eines dynamischen Referenzsignals.
**Fig. 8** zeigt verschiedene Signale in der Vorrichtung zum Erzeugen eines dynamischen Referenzsignals aus Fig. 7.

## Ausführliche Beschreibung

In der folgenden Beschreibung werden zahlreiche Details aufgeführt, um ein tiefgreifendes Verständnis der vorliegenden Erfindung zu ermöglichen. Es ist dem Fachmann jedoch klar, dass die spezifischen Details nicht notwendig sind, um die vorliegende Erfindung umzusetzen. An anderer Stelle sind bekannte Vorrichtungen und Verfahren nicht detailliert geschildert, um das Verständnis der vorliegenden Erfindung nicht unnötig zu erschweren.

In der vorliegenden Beschreibung bedeutet eine Bezugnahme auf "eine Ausführung", "einer Ausgestaltung", "ein Beispiel" oder "Beispiel", dass ein bestimmtes Merkmal, eine Struktur oder Eigenschaft, die in Verbindung mit dieser Ausführungsform beschrieben ist, in mindestens einer Ausführungsform der vorliegenden Erfindung beinhaltet ist. So beziehen sich die Phrasen "in einer Ausführung", "in einer Ausführungsform", "ein Beispiel" oder "Beispiel" an verschiedenen Stellen in dieser Beschreibung nicht unbedingt alle auf dieselbe Ausführungsform oder dasselbe Beispiel. Ferner können die bestimmten Merkmale, Strukturen oder Eigenschaften in beliebigen geeigneten Kombinationen und / oder Unterkombinationen in einer oder mehreren Ausführungsformen oder Beispielen kombiniert werden. Besondere Merkmale, Strukturen oder Eigenschaften können in einer integrierten Schaltung, in einer elektronischen Schaltung, in einer Schaltungslogik oder in anderen geeigneten Komponenten beinhaltet sein, die die beschriebene Funktionalität bereitstellen. Darüber hinaus wird darauf hingewiesen, dass die Zeichnungen zum Zwecke der Erläuterung für den Fachmann dienen und dass die Zeichnungen nicht notwendigerweise maßstabsgetreu gezeichnet sind.

Die oben beschriebenen Unterschiede im Verlauf der Kollektor-Emitter-Spannung zwischen Normalbetrieb und Kurzschluss- und/oder Überstrombetrieb können in Schutzschaltungen ausgenützt werden, um einen Kurzschluss- oder Überstromzustand zu detektieren. Zum Beispiel kann, wenn die Kollektor-Emitter-Spannung über den Schwellwert steigt (siehe Figur 6 rechts unten), ein Kurzschluss- oder Überstromzustand detektiert werden. Allerdings muss der Abfall der Kollektor-Emitter-Spannung nicht monoton sein. Er kann, wie ebenfalls in Figur 6 dargestellt - gerade kurz nach dem Anschalten des Leistungshalbleiterschalters - Spannungsspitzen und Spannungstäler aufweisen. Das kann bei einer statischen Referenzspannung dazu führen, dass die Schutzschaltung fälschlicherweise einen Kurzschluss- und/oder Überstromfall annimmt und den Leistungshalbleiterschalter ausschaltet. Ebenfalls kann bei Leistungshalbleiterschaltern mit verhältnismäßig trägem Umschaltverhalten die Zeit, bis ein statischer Zustand erreicht wird, verhältnismäßig lang sein (z.B. deutlich länger als 10 $\mu$s). Eine statische Referenzspannung, die nahe einer spezifischen statischen Flussspannung des Leistungshalbleiterschalters eingestellt ist, kann somit ebenfalls dazu führen, dass die Schutzschaltung fälschlicherweise einen Kurzschluss- und/oder Überstromfall annimmt und den Leistungshalbleiterschalter ausschaltet. In diesem Fall kann die Schutzschaltung eine gefährlich erhöhte Spannung detektieren, obwohl der zu einem bestimmten Zeitpunkt erhöhte Spannungspegel lediglich der Trägheit des Leistungshalbleiterschalter zuzurechnen ist.

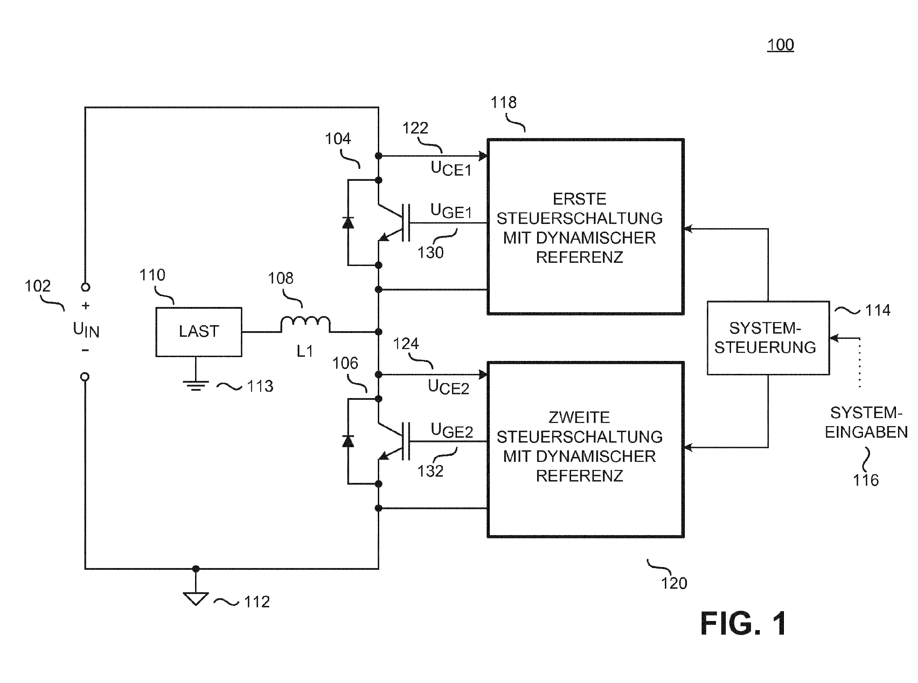

**Fig. 1** zeigt eine Vorrichung 100 (auch als Leistungswandler bezeichnet) zur Bereitstellung von elektrischer Energie an einen Verbraucher 110. Allerdings kann der Energiefluss auch in die andere Richtung zeigen. Dann handelt es sich bei Element 110 um einen Erzeuger. In wieder anderen Vorrichtungen kann Element 110 in verschiedenen Betriebszuständen sowohl als Verbraucher, als auch als Erzeuger arbeiten. In der Folge wird lediglich von einer Vorrichtung zur Bereitstellung von Energie gesprochen, was alle soeben besprochenen Fälle umfasst (die Energie kann an verschiedenen Ausgängen bereitgestellt werden). Die Vorrichtung umfasst zwei Leistungshalbleiterschalter 104, 106, die in Serie geschaltet sind. Zudem kann Vorrichtung 100 eine Eingangsgleichspannung 102 ($U_{IN}$) empfangen. Die Vorrichtung ist dazu ausgelegt, elektrische Energie durch Steuerung der Leistungshalbleiterschalters 104, 106 von dem Eingang an einen Ausgang zu übertragen, an den der Verbraucher 110 angeschlossen ist (oder in umgekehrte Richtung). Dabei kann die Vorrichtung zur Bereitstellung von elektrischer Energie Spannungspegel, Strompegel oder eine Kombination der beiden Größen, die an den Verbraucher abgegeben werden, steuern.

Im Beispiel von **Fig. 1** sind die Leistungshalbleiterschalter 104, 106 IGBTs. In der Folge werden die Vorrichtungen und Verfahren am Beispiel von IGBTs erläutert. Allerdings sind die Vorrichtungen zum Erzeugen eines dynamischen Referenzsignals, die Steuerschaltungen und die erfindungsgemäßen Vorrichtungen zur Bereitstellung von elektrischer Energie nicht auf den Einsatz mit IGBTs beschränkt. Vielmehr können sie auch in Kombination mit anderen Leistungshalbleiterschaltern verwendet werden. Zum Beispiel können MetallOxid-Halbleiter-Feldeffekttransistor (MOSFETs), Bipolartransistoren, IEGTs ("injection enhancement gate transistors") und GTOs ("gate turn-off thyristors") mit den Vorrichtungen zum Erzeugen eines dynamischen Referenzsignals, die Steuerschaltungen und die erfindungsgemäßen Vorrichtungen zur Bereitstellung von elektrischer Energie verwendet werden. Auch können die Vorrichtungen zur Detektion eines Verlaufs einer Spannung über einem Leistungshalbleiterschalter, die Steuerschaltungen und die Vorrichtungen zur Bereitstellung von elektrischer Energie mit Leistungshalbleiterschaltern verwendet werden, die auf Galliumnitrid-(GaN)-Halbleitern oder Siliziumkarbid-(SiC)-Halbleitern basieren. Eine maximale nominale Kollektor-Emitter-, Anoden-Kathoden oder Drain-Source-Spannung eines Leistungshalbleiterschalters im ausgeschalteten Zustand kann mehr als 500 V, bevorzugt mehr als 2 kV, betragen.

Zudem sind die Vorrichtungen zum Erzeugen eines dynamischen Referenzsignals, die Steuerschaltungen und die erfindungsgemäßen Vorrichtungen zur Bereitstellung von elektrischer Energie nicht auf Leistungshalbleiterschalter beschränkt. So können auch andere Halbleiterschalter mit den Vorrichtungen zur Detektion eines Verlaufs einer Spannung über einem Leistungshalbleiterschalter, die Steuerschaltungen und die Vorrichtungen zur Bereitstellung von elektrischer Energie verwendet werden. Die Effekte und Vorteile, die hier besprochen werden, treten zumindest teilweise auch in Systemen mit anderen Halbleiterschaltern auf. Da in der Folge IGBTs diskutiert werden, werden die Anschlüsse des Leistungshalbleiterschalters als "Kollektor", "Gate" und, "Emitter" bezeichnet. Wir bereits oben erläutert, sind die Vorrichtungen und Verfahren jedoch nicht auf IGBTs beschränkt. Um unnötige Längen zu vermeiden, umfasst die Bezeichnung "Emitter" hierin auch den mit "Source" oder "Kathode" bezeichneten Anschluss entsprechender Leistungshalbleiterschalter. Gleichermaßen umfasst der Begriff "Kollektor" hierin auch den mit "Drain" oder "Anode" bezeichneten Anschluss und der Begriff "Gate" den mit "Basis" bezeichneten Anschluss entsprechender Leistungshalbleiterschalter. In der Folge umfasst der Begriff "Kollektor-Emitter-Spannung" auch eine "Drain-Source-Spannung" und eine "Kathoden-Anoden-Spannung" und die Begriffe "Kollektor- Spannung" und "Emitter-Spannung" auch eine "Drain-Spannung" oder "Anoden-Spannung" beziehungsweise eine "Source-Spannung" oder "Kathoden-Spannung".

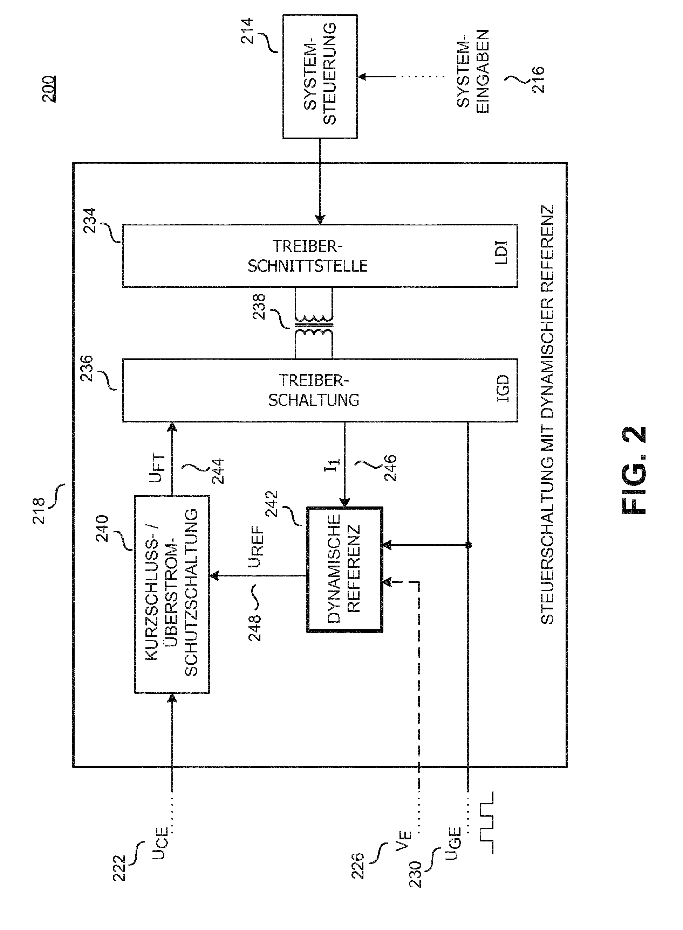

Die Leistungshalbleiterschalter 104, 106 werden jeweils von einer ersten und zweiten Steuerschaltung 118, 120 gesteuert (eine beispielhafte Steuerschaltung wird im Zusammenhang mit **Fig. 2** erläutert). Diese stellen ein erstes und ein zweites Gate-Emitter-Treibersignal 130, 132 ($U_{GE1}$, $U_{GE2}$) bereit, um die Schaltzeitpunkte des ersten und zweiten IGBTs zu steuern. Beide Steuerschaltungen 118, 120 können optional wiederum von einer Systemsteuerung 114 gesteuert werden. Die Systemsteuerung 114 kann einen Eingang zum Empfangen von System-Eingabesignalen 116 aufweisen. In dem Beispiel von **Fig. 1** sind zwei Leistungshalbleiterschalter 104, 106 in einer Halbbrücken-Konfiguration dargestellt. Die Vorrichtungen zum Erzeugen eines dynamischen Referenzsignals, die Steuerschaltungen und die Vorrichtungen zur Bereitstellung von elektrischer Energie können jedoch auch in anderen Topologien eingesetzt werden. Beispielsweise kann ein einzelner Leistungshalbleiterschalter (z.B. ein einzelner IGBT) mit einer Vorrichtung zum Erzeugen eines dynamischen Referenzsignals oder einer Steuerschaltung beschaltet werden. In anderen Beispielen kann in einem dreiphasigen System mit sechs Leistungshalbleiterschaltern oder zwölf Leistungshalbleiterschaltern jeder der Leistungshalbleiterschalter eine Vorrichtung zum Erzeugen eines dynamischen Referenzsignals aufweisen. Neben der Ausgabe eines Gate-Emitter-Treibersignals nehmen die Steuerschaltungen 118, 120 Signale auf, die Spannungen, die über den Leistungshalbleiterschaltern 104, 106 anliegen, repräsentieren. Bei den Signalen kann es sich um Spannungssignale oder Stromsignale handeln. Im Beispiel von **Fig. 1** weist jede Steuerschaltung 118, 120 jeweils ein Signal, das für die Kollektor-Emitter-Spannung repräsentativ ist und als Kollektor-Emitter-Spannungssignal 122, 124 ($U_{CE1}$, $U_{CE2}$) bezeichnet wird, auf.

In **Fig. 1** und in der Folge werden Schaltungen beschrieben, in denen Signale verwendet werden, die Spannungen repräsentieren, die über den Leistungshalbleiterschaltern 104, 106 anliegen (beispielsweise ein Kollektor-Emitter-Spannungssignal). Wie weiter oben erläutert, kann die indirekte Überwachung des Stroms durch den Leistungshalbleiterschalter anhand der Spannungen, die über einem Leistungshalbleiterschalter anliegen erfolgen. Allerdings kann ein Stroms durch den Leistungshalbleiterschalter (z.B. ein Kollektorstrom, ein Drainstrom oder ein Kathodenstrom) auch in anderer Weise abgeschätzt werden oder direkt gemessen werden. In einem Beispiel kann eine Vorrichtung (auch als Leistungswandler bezeichnet) zur Bereitstellung von elektrischer Energie an einen Verbraucher eine Detektionsschaltung zur direkten Messung eines Stroms durch einen Leistungshalbleiterschalter aufweisen (z.B. eine Vorrichtung zur Messung eines Kollektorstroms).

In **Fig. 1** sind die Steuerschaltungen 118, 120 als separate Steuerschaltungen skizziert. Allerdings können beide Steuerschaltungen 118, 120 auch in einer einzigen Schaltung kombiniert sein. In diesem Fall steuert eine einzige Steuerschaltungen zwei Leistungshalbleiterschalter 104, 106. Darüber hinaus kann das zweite Gate-Emitter-Treibersignal 132 ($U_{GE2}$) ein invertiertes erstes Gate-Emitter-Treibersignal 130 ($U_{GE1}$) sein.

Beide Steuerschaltungen 118, 120 umfassen eine Vorrichtung zum Erzeugen eines dynamischen Referenzsignals. Mit deren Hilfe kann, basierend auf den jeweiligen Kollektor-Emitter-Spannungssignal 122, 124 ein Kurzschluss- und/oder Überstromzustand des jeweiligen Leistungshalbleiterschalters festgestellt werden. In Reaktion auf die Feststellung eines Kurzschluss- und/oder Überstromzustands kann der jeweilige Leistungshalbleiterschalter 104, 106 abgeschaltet werden.

In **Fig. 2** ist eine Steuerschaltung 218 dargestellt (zum Beispiel eine der Steuerschaltungen 118, 120 aus **Fig.** 1). Die Steuerschaltung 218 beinhaltet vier funktionale Einheiten: Eine Vorrichtung zum Erzeugen eines dynamischen Referenzsignals 242, eine Kurzschluss- und/oder Überstromzustand-Detektionsschaltung 240, eine Treiberschaltung 236 und eine optionale Treiberschnittstelle 234. Die Vorrichtung zum Erzeugen eines dynamischen Referenzsignals 242 ist angepasst, um ein Gate-Emitter-Treibersignal 230 von der Treiberschaltung 236 zu empfangen. Allerdings kann eine Vorrichtung zum Erzeugen eines dynamischen Referenzsignals 242 auch andere Signale, die für das Gate-Emitter-Treibersignal 230 repräsentativ sind, empfangen. Es ist lediglich notwendig, dass dem Signal eine Information bezüglich des Zeitpunkts eines Umschaltvorgangs des gesteuerten Leistungshalbleiteschalters von einem ausgeschalteten Zustand in einen angeschalteten Zustand entnommen werden kann (und optional Information bezüglich des Zeitpunkts eines Umschaltvorgangs des gesteuerten Leistungshalbleiteschalters von einem angeschalteten Zustand in einen ausgeschalteten Zustand). Zusätzlich ist die Vorrichtung zum Erzeugen eines dynamischen Referenzsignals 242 optional ausgelegt, ein externes Referenzsignal zu empfangen. Im Beispiel von **Fig. 2** kann das externe Referenzsignal ein Referenzsignal 226 sein, das repräsentativ für die Emitterspannung eines Leistungshalbleiterschalters ist. Allerdings können alternativ auch andere Spannungspegel als externes Referenzsignal verwendet werden, die um einen konstanten Offset gegenüber der Emitterspannung eines Leistungshalbleiterschalters versetzt sind.

Außerdem ist die die Vorrichtung zum Erzeugen eines dynamischen Referenzsignals 242 ausgelegt, um ein

Konstantstromsignal 246 ($I_1$) zu empfangen. Im Beispiel von **Fig. 2** wird das Konstantstromsignal 246 von der Treiberschaltung 236 bereitgestellt. Auch das Konstantstromsignal 246 kann alternativ von anderen funktionellen Einheiten der Steuerschaltung 218 oder auch von einer externen Quelle bereitgestellt werden oder intern von der Schaltung zur Erzeugung des Referenzsignals selbst erzeugt werden. Zur Erzeugung des Konstantstroms 246 kommt jede geeignete Quelle für Strom in Betracht. Basierend auf den empfangenen Signalen (also dem Konstantstromsignal 246 und dem Gate-Emitter-Treibersignal 230) stellt die Vorrichtung zum Erzeugen eines dynamischen Referenzsignals 242 ein dynamisches Referenzsignal 248 bereit. Dieses wird von der Kurzschluss- und/oder Überstromzustand-Detektionsschaltung 240 empfangen. Das dynamische Referenzsignal 248 hat nach Verstreichen einer vorbestimmten Zeit nach einem Umschaltvorgang des Leistungshalbleiterschalters einen stationären Signalpegel. Wenn der Leistungshalbleiterschalter von einem AUS-Zustand in einen AN-Zustand schaltet, ist das dynamische Referenzsignal 248 mindestens in einem Teil eines Zeitraums ab dem Umschaltvorgang des Leistungshalbleiterschalters bis zum Verstreichen der vorbestimmten Zeit über den stationären Signalpegel erhöht. Der stationäre Signalpegel des dynamischen Referenzsignals muss jedoch nicht in allen Betriebssituationen gleich sein. So ist ein Driften oder eine im Verhältnis zu einer Länge eines Schaltzyklus langsame Veränderung des stationären Signalpegels möglich. Auch kann der stationäre Signalpegel einstellbar sein.

Die Kurzschluss- und/oder Überstromzustand-Detektionsschaltung 240 ist ihrerseits dazu ausgelegt, ein Signal 222 zu empfangen, das der Kollektor-Emitter-Spannung $U_{CE}$ eines Leistungshalbleiterschalters entspricht (zum Beispiel Signale 122 oder 124 aus **Fig. 1).** Basierend auf diesem Signal 222, das der Kollektor-Emitter-Spannung des Leistungshalbleiterschalters entspricht, ermittelt die Kurzschluss- und/oder Überstromzustand-Detektionsschaltung 240 ein Signal, das für eine Kollektor-Emitter-Spannung über dem Leistungshalbleiterschalter repräsentativ ist ($U_{C'E}$). In anderen Beispielen ermittelt die Kurzschluss- und/oder Überstromzustand-Detektionsschaltung 240 dieses Signal aus anderen Signalen oder empfängt ein Signal, das für eine Kollektor-Emitter-Spannung über dem Leistungshalbleiterschalter repräsentativ ist, von einem weiteren Schaltungsblock. In weiteren Beispielen empfängt die Kurzschluss- und/oder Überstromzustand-Detektionsschaltung 240 ein Signal, dass für einen Strom durch den Leistungshalbleiterschalter repräsentativ ist (z.B. für einen Kollektorstrom). Wie im Zusammenhang mit Fig. 1 ausgeführt, kann das Signal, dass für einen Strom durch den Leistungshalbleiterschalter repräsentativ ist, durch eine direkte Messung des Stroms durch den Leistungshalbleiterschalter erzeugt werden. Die Kurzschluss- und/oder Überstromzustand-Detektionsschaltung 240 kann dann das Signal, dass für einen Strom durch den Leistungshalbleiterschalter repräsentativ ist mit dem dynamischen Referenzsignal vergleichen, um ein Vorliegen eines Kurzschluss- und/oder Überstromzustands in dem Leistungshalbleiterschalter zu detektieren. Beispielhafte Verläufe eines Signals, dass für einen Strom durch den Leistungshalbleiterschalter repräsentativ ist sind in Fig. 6 unten gezeigt (am Beispiel des Kollektorstroms $I_{C'}$). Dort ist auch erkennbar, dass die Normal- und Kurzschluss- und/oder Überstromzustände sowohl an einer kennzeichnenden Änderung des Verlaufs des Stroms direkt, als auch an einer kennzeichnenden Änderung des Verlaufs der Spannung indirekt detektiert werden können.

In Antwort auf das empfangene oder ermittelte Signal, das für eine Kollektor-Emitter-Spannung über dem Leistungshalbleiterschalter repräsentativ ist (oder ein empfangenes oder ermitteltes Signal, das für den Kollektorstrom durch den Leistungshalbleiterschalter repräsentativ ist) und dem empfangenen dynamische Referenzsignal 248 ermittelt die Kurzschluss- und/oder Überstromzustand-Detektionsschaltung 240, ob ein Kurzschluss- und/oder Überstromzustand vorliegt.

In einem Beispiel detektiert die Kurzschluss- und/oder Überstromzustand-Detektionsschaltung 240, dass ein Kurzschluss- und/oder Überstromzustand vorliegt, wenn das Signal, das für die Kollektor-Emitter-Spannung repräsentativ ist (oder das Signal, das für den Kollektorstrom durch den Leistungshalbleiterschalter repräsentativ ist), größer ist als das dynamische Referenzsignal 248. Wie bereits weiter oben beschrieben, sollte die Kollektor-Emitter-Spannung (oder der Kollektorstrom) nach Anschalten des Leistungshalbleiterschalters schnell auf einen relativ geringen Wert absinken und eine über diesen Wert erhöhte Kollektor-Emitter-Spannung (oder ein erhöhter Kollektorstrom) ist ein indirekter (oder direkter) Indikator für das Vorliegen eines Kurzschluss- und/oder Überstromzustands. Die unteren Kurven in Fig. 6 verdeutlichen dieses und die Operation der Kurzschluss- und/oder Überstromzustand-Detektionsschaltung 240. Auf der linken Seite von Fig. 6 ist ein normaler Einschaltvorgang dargestellt. Die Spannung $U_{C'E}$ (in diesem Fall das Signal, das für die Kollektor-Emitter-Spannung repräsentativ ist) sinkt nach dem Schaltvorgang schnell ab. Der Strom $I_{C'}$(in diesem Fall das Signal, das für den Kollektor-Strom repräsentativ ist) erreicht ebenfalls zügig einen mehr oder minder stationären Pegel. Das dynamische Referenzsignal liegt immer über dem Signal $U_{C'E}$ 678 (oder über einem Signal, das für den Kollektor-Strom repräsentativ ist), so dass kein Kurzschluss- und/oder Überstromzustand festgestellt wird. Wie bereits erwähnt kann die zeitweise Erhöhung des Pegels des dynamischen Referenzsignals nach dem Umschaltvorgang eine fälschliche Detektion eines Kurzschluss- und/oder Überstromzustand verhindern.

Auf der rechten Seite unten in Fig. 6 ist dagegen ein typischer Verlauf des Signals, das für die Kollektor-Emitter-Spannung repräsentativ ist und der Verlauf des Signals, das für den Kollektor-Strom repräsentativ ist in einem Kurzschluss- und/oder Überstromfall skizziert. Hier ist zu erkennen, dass das Signal $U_{C'E}$ 678 und das Signal $I_{C'}$ das dynamische Referenzsignal übersteigen (z.B. nach 8 bis 12 $\mu$s nach einem Umschaltvorgang) und so die Kurzschluss-und/oder Überstromzustand-Detektionsschaltung 240 einen Kurzschluss- und/oder

Überstromzustand detektiert. Wie vorstehend erläutert wird das dynamische Referenzsignal für mindestens einen Teil einer vorbestimmte Zeit (zum Beispiel für die gesamte vorbestimmte Zeit) erhöht, so dass kein Fehler detektiert wird, wenn während der vorbestimmten Zeit Spannungsspitzen und Spannungstäler nach dem Anschalten des Leistungshalbleiterschalters auftreten, oder das komplette Absinken des der Kollektor-Emitter-Spannung repräsentativen Signals auf einen niedrigen Wert unterhalb des statischen Referenzsignals grundsätzlich länger dauert, als die für den Leistungshalbleiterschalter maximal zulässige Kurzschlussdauer definiert ist. Die Dauer der Erhöhung des dynamischen Referenzsignals kann eingestellt werden, um die Häufigkeit des Auftretens von falschen Fehlerdetektionen zu minimieren. Wie in Fig. 6 zu sehen, kann ein ausreichend starkes Ansteigen des Signals, das für die Kollektor-Emitter-Spannung repräsentativ ist oder des Signals, das für den Kollektorstrom durch den Leistungshalbleiterschalter repräsentativ ist trotz der dynamischen Erhöhung des Referenzsignals während der vorbestimmten Zeit die Detektion eines Kurzschluss- und/oder Überstromzustands auslösen. Es kann lediglich sein, dass der Zeitpunkt der Detektion durch die dynamische Erhöhung des Referenzsignals nach hinten verschoben wird.

Die Überstromzustand-Detektionsschaltung 240 kann, wenn sie einen Kurzschluss- und/oder Überstromzustand detektiert hat, ein Fehlersignal ausgeben. Im Beispiel von Fig. 2 wird ein Fehlersignal 244 ($U_{FT}$) an die Treiberschaltung 236 abgegeben. Diese kann in Reaktion auf das Fehlersignal 244 den Leistungshalbleiterschalter abschalten, um Schaden an diesem zu verhindern. Allerdings kann in alternativen Anordnungen das Fehlersignal auch in anderer Weise verarbeitet werden. Zum Beispiel kann lediglich das Fehlersignal 250 ($U_{FT}$) an ein weiteres Steuerelement (beispielsweise an die Systemsteuerung 214) geliefert werden. Dieses weitere Element kann dann zwei oder mehr Leistungshalbleiterschalter in einer vorbestimmten Sequenz abschalten.

Um das Fehlersignal zu ermitteln, kann die Kurzschluss- und/oder Überstromzustand-Detektionsschaltung 240 die empfangenen Signale weiterverarbeiten. Zum Beispiel kann die Kurzschluss- und/oder Überstromzustand-Detektionsschaltung 240 eine Austastschaltung beinhalten, um eine vorbestimmte Verzögerung der Detektion eines Kurzschluss- und/oder Überstromzustands einzustellen. Zudem oder alternative kann die Kurzschluss- und/oder Überstromzustand-Detektionsschaltung 240 eine Schaltung enthalten, um einen Spannungspegel des Signals, das für die Kollektor-Emitter-Spannung repräsentativ (oder eines Signals, dass für den Kollektorstrom des Leistungshalbleiterschalters repräsentativ ist) ist, einzustellen. Da die Kollektor-Emitter-Spannung selbst einige tausend Volt oder mehr betragen kann, kann diese Schaltung ein Netzwerk mit hochohmigen Widerständen umfassen. Das Netzwerk kann aber noch weitere für hohe Spannungen ausgelegte Elemente beinhalten (z. B. kapazitive Komponenten oder Dioden). Dieses erzeugt aus der Kollektor-Emitter-Spannung ein Signal, dass proportional zu der Kollektor-Emitter-Spannung, aber einen (viel) geringeren Spannungspegel hat (beispielsweise das in **Fig. 6** skizzierte Signal $U_{C'E}$).

Wie bereits beschrieben, kann die Treiberschaltung 236 ein Fehlersignal 244, das einen Kurzschluss- und/oder Überstromzustand signalisiert, empfangen und den Leistungshalbleiteschalter in Reaktion auf einen detektierten Kurzschluss- und/oder Überstromzustand abschalten. Eine oder mehrere Komponenten der Kurzschluss- und/oder Überstromzustand-Detektionsschaltung 240 können optional in der Treiberschaltung 236 beinhaltet sein. Beispielsweise kann die Treiberschaltung 236 das dynamische Referenzsignal $U_{REF}$ 248 und das Signal, das für die Kollektor-Emitter-Spannung repräsentativ ist (oder ein Signal, das für den Kollektorstrom durch den Leistungshalbleiterschalter repräsentativ ist), empfangen. Außerdem kann die Treiberschaltung 236 auch ein Gate-Emitter-Treibersignal zum Steuern des Leistungshalbleiteschalters liefern.

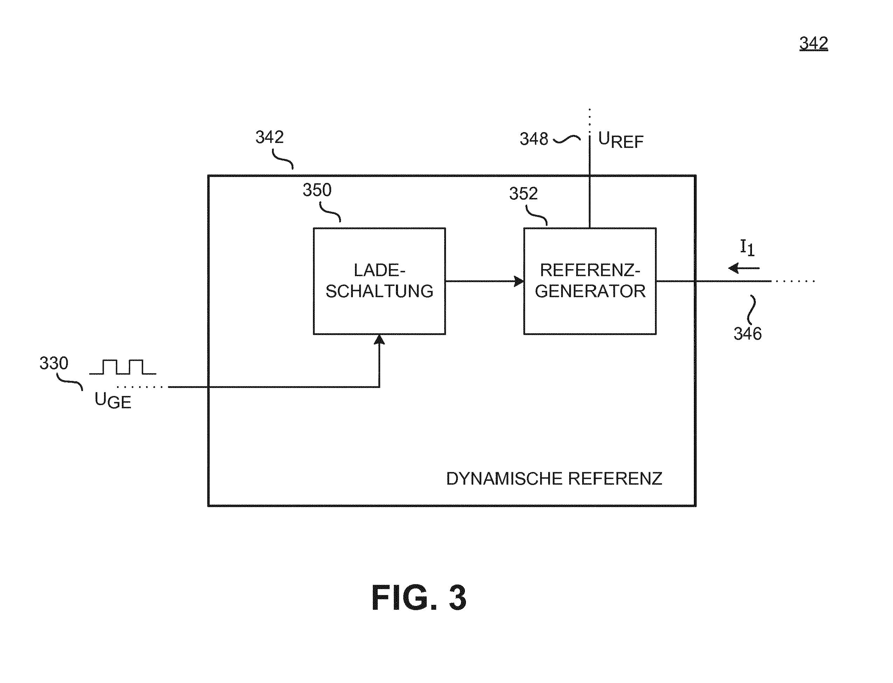

Im Beispiel von **Fig. 2** ist die Treiberschaltung 236 über eine galvanische Isolation 238 (z.B. einen Transformator) mit der optionalen Treiberschnittstelle 234 verbunden, um Steuersignale von der Systemsteuerung 214 zu empfangen. Die Treiberschnittstelle 234 kann wiederum mit der Systemsteuerung 214 verbunden sein, die Systemeingaben 216 empfängt, und von dieser gesteuert wird. In **Fig. 3** ist eine beispielhafte Vorrichtung zum Erzeugen eines dynamischen Referenzsignals 342 (zum Beispiel Block 242 in Fig. 2) für eine Steuerschaltung für einen Leistungshalbleiterschalter dargestellt. Die Vorrichtung zum Erzeugen eines dynamischen Referenzsignals 342 enthält zwei funktionale Blöcke, einen Referenzsignal-Generator 352 und eine passive Lade-Schaltung 350. Die Funktion diese Blöcke wird in der Folge erläutert. Die beispielhafte Schaltung ist jedoch nicht auf Fälle beschränkt, in denen die unten erläuterten Funktionen in getrennten Einheiten ausgeführt werden. Vielmehr können ein Teil oder alle Funktionen eines Blocks auch gemeinsam implementiert werden.

Die Vorrichtung zum Erzeugen eines dynamischen Referenzsignals 342 empfängt ein Steuersignal des Leistungshalbleiterschalters 330 ($U_{GE}$), und ein Konstantstromsignal 346 ($I_1$).

In **Fig. 3** und in den folgenden Figuren empfangen die Vorrichtungen zum Erzeugen eines dynamischen Referenzsignals ein Konstantstromsignal. Wie bereits weiter oben erläutert, sind auch andere Ausgestaltungen möglich. In einem Beispiel empfängt die Vorrichtungen zum Erzeugen eines dynamischen Referenzsignals ein Konstantspannungssignal.

Das Steuersignal des Leistungshalbleiterschalters 330 ($U_{GE}$) kann jedes Signal sein, das den zeitlichen Ablauf der Umschaltvorgänge des Leistungshalbleiterschalters repräsentiert. Zum Beispiel kann, wie in **Fig. 1** gezeigt, das Gate-Treibersignal verwendet werden. Allerdings kann (vor allem in einer komplexen IGBT-Treiberschaltung) auch an anderen Stellen ein geeignetes Signal vorhanden sein, um die Vorrichtung zum Erzeugen eines dynamischen Referenzsignals 342 mit Informationen über die Umschaltvorgänge des Leistungshalbleiterschalters zu versorgen. Das Konstantstromsignal 346 (oder ein Konstantspannungssignal) kann auch in der Vorrichtung zum Erzeugen eines dynamischen Referenzsignals 342 selbst erzeugt werden.

Der Referenzsignal-Generator 352 der Vorrichtung zum Erzeugen eines dynamischen Referenzsignals 342 stellt ein dynamisches Referenzsignal 348 ($U_{REP}$ oder $I_{REF}$) zur Verfügung, das nach Verstreichen einer vorbestimmten Zeit nach einem Umschaltvorgang des Leistungshalbleiterschalters einen stationären Signalpegel hat. Zum Bespiel kann der Referenzsignal-Generator 352 eine oder mehrere Komponenten zum Erzeugen des stationären Signalpegels in Antwort auf das Konstantstromsignal 346 (oder ein Konstantspannungssignal) umfassen.

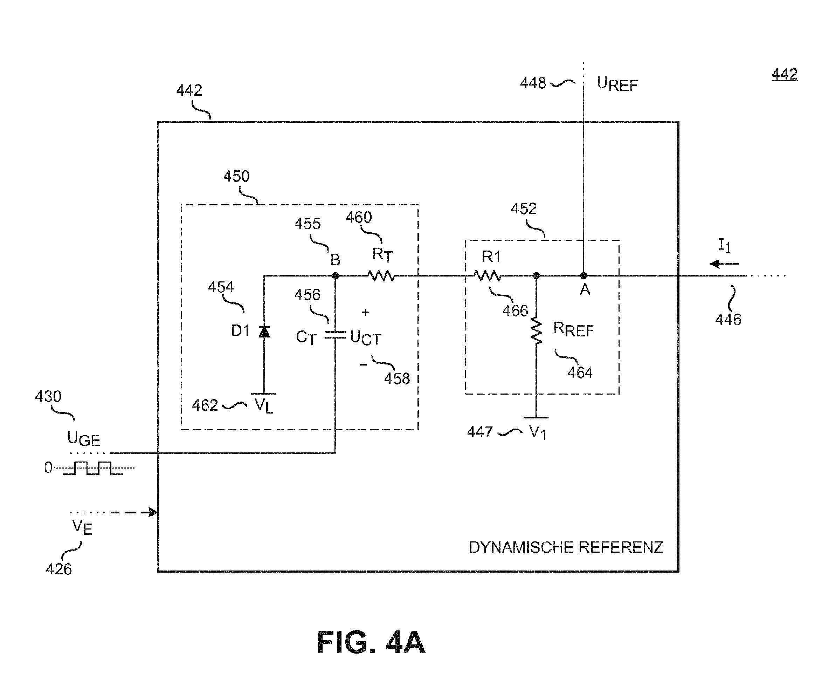

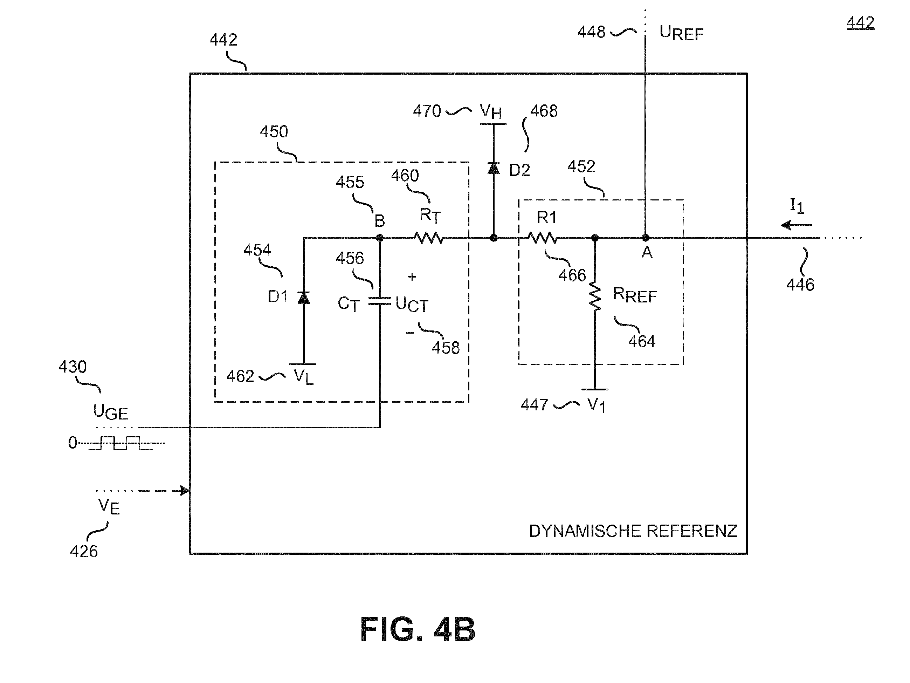

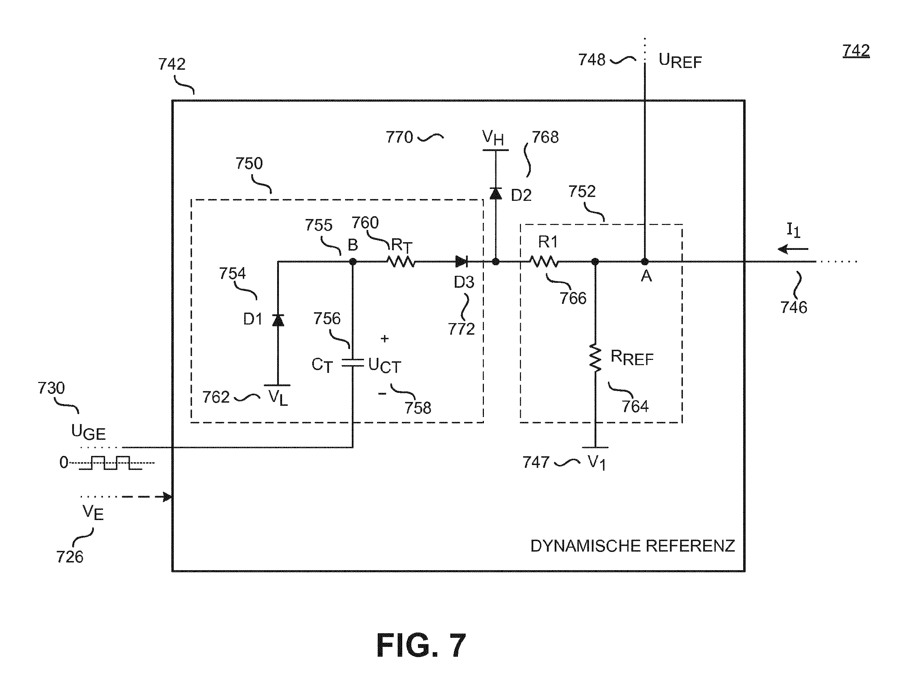

Beispiele für den Referenzsignal-Generator 352 werden im Zusammenhang mit **Fig. 4A, Fig. 4B** und **Fig. 7** gezeigt.

Die passive Lade-Schaltung 350 ist ausgelegt, um einen um einen Signalpegel des dynamischen Referenzsignals in Reaktion auf ein Umschalten eines Steuersignals des Leistungshalbleiterschalters von einem AUS-Zustand in einen AN-Zustand zumindest für einen Teil der vorbestimmten Zeit (zum Beispiel für die gesamte vorbestimmte Zeit) über den stationären Signalpegel zu erhöhen zur Erzeugung eines dynamischen Referenzsignals. Beispielsweise empfängt die passive Lade-Schaltung 350 das Steuersignal $U_{GE}$ 330. Das Steuersignal $U_{GE}$ 330 wird von der passiven Lade-Schaltung 350 verarbeitet, um den Zeitpunkt des Umschaltvorgangs eines Steuersignals des Leistungshalbleiterschalters von einem ausgeschalteten Zustand in einen angeschalteten Zustand zu bestimmen. Zudem kann die Amplitude und der zeitliche Verlauf (also auch die Länge des Teils oder der gesamten vorbestimmten Zeit, in der das dynamische Referenzsignal 348 einen erhöhten Signalpegel aufweist) der Erhöhung des dynamischen Referenzsignals über den stationären Signalpegel zumindest teilweise basierend auf dem Steuersignal $U_{GE}$ 330 bestimmt werden. Diese zeitweise Erhöhung des dynamischen Referenzsignals bewerkstelligt die passive Lade-Schaltung 350 ohne aktive Bauelemente (wie beispielsweise Transistoren). Beispielhafte passive Lade-Schaltungen 350 sind wiederum in Zusammenhang mit **Fig. 4A, Fig. 4B** und **Fig. 7** gezeigt.

In einem Beispiel ist die passive Lade-Schaltung 350 dazu konfiguriert, den zeitlichen Verlauf der zeitweisen Erhöhung des dynamischen Referenzsignals wie in **Fig. 6** dargestellt zumindest teilweise zu steuern. Das umfasst einen sprunghaften Anstieg in Reaktion auf ein Umschalten eines Steuersignals des Leistungshalbleiterschalters von einem AUS-Zustand in einen AN-Zustand gefolgt von einem kontinuierlichen Absinken zurück auf den Pegel des stationären Spannungssignals. Die Zeitkonstante (1/e-Zeitkonstante) des Absinkens kann zwischen 1 und 50 μs (z.B. zwischen 5 und 15 μs) liegen. Um dieses zeitliche Verhalten des dynamischen Referenzsignals 348 zu erzeugen, kann die passive Lade-Schaltung 350 ein RC-Glied enthalten, wobei die Zeitkonstante einer Kapazität des RC-Gliedes das Tempo des Absinkens auf Pegel des stationären Spannungssignals zumindest teilweise bestimmt. Zudem kann der Anstieg des Pegels des dynamischen Referenzsignals 348 über den Pegel des statischen Referenzsignals mit einem Sprung in der Amplitude des Steuersignals $U_{GE}$ 330 korrelieren. Im Zusammenhang mit **Fig. 6** werden beispielhafte Signalpegel erläutert.

**Fig. 4A** zeigt ein erstes Beispiel eines einer Vorrichtung zum Erzeugen eines dynamischen Referenzsignals 442. Die Vorrichtung enthält einen Referenzsignal-Generator 452 und eine passive Lade-Schaltung 450. Zudem empfängt die Vorrichtung zum Erzeugen eines dynamischen Referenzsignals 442, wie auch im Beispiel von **Fig. 3,** ein Steuersignals des Leistungshalbleiterschalters 430 ($U_{GE}$), ein Konstantstromsignal 446 ($I_1$). In Bezug auf die Auswahl dieser Signale und alternative Signale gilt das an der entsprechenden Stelle in der Beschreibung von **Fig. 3** gesagte.

Referenzsignal-Generator 452 enthält eine Schaltung zum Erzeugen eines statischen Referenzsignals. Die Schaltung zum Erzeugen eines statischen Referenzsignals beinhaltet einen Referenzwiderstand 464 ($R_{REF}$). Das Konstantstromsignal 346 ist an einen ersten Anschluss des Referenzwiderstands 464 gekoppelt, fließt durch den Referenzwiderstand 464 und erzeugt so einen konstanten Spannungsabfall ($I_1*R_{REF}$). Auch wenn in **Fig. 4A** der Referenzwiderstand 464 als einzelnes Bauelement dargestellt ist, kann auch eine Kombination aus mehreren Widerständen eingesetzt werden.

In anderen Beispielen kann eine Konstantspannungsquelle in den Vorrichtungen zum Erzeugen eines dynamischen Referenzsignals eingesetzt werden (statt der Erzeugung dieser durch den Abfall des Konstantstroms $I_1$ über dem Referenzwiderstand $R_{REF}$ 464). In einem Beispiel kann eine konstante Spannungsquelle in Serie zu dem Referenzwiderstand $R_{REF}$ 464 (gewissermaßen an Stelle von VI) geschaltet sein. Zum Beispiel kann die konstante Spannungsquelle zwischen dem Referenzwiderstand $R_{REF}$ und $V_E$ geschaltet sein. In anderen Beispielen kann dabei ein bereits in den Vorrichtungen zum Erzeugen eines dynamischen Referenzsignals vorhandenes interner Referenzpegel den statischen Spannungsreferenzpegel bilden (z.B. der interne Referenzpegel 447 ($V_1$)). Zum Beispiel kann der interne Referenzpegel durch eine passive Halbleiterschaltung (z.B. mit einer Zenerdiode) erzeugt werden. In einem anderen Beispiel kann der Referenzwiderstand $R_{REF}$ 464 weggelassen werden. Die Vorrichtungen zum Erzeugen eines dynamischen Referenzsignals erzeugt dann einen Referenzstrom $I_{REF}$ (statt einer Referenzspannung $U_{REF}$).

Die Vorrichtung zum Erzeugen eines dynamischen Referenzsignals 442 erzeugt einen ersten internen Referenzpegel 447 ($V_1$). Zum Beispiel kann der erste interne Referenzpegel 447 ($V_1$) basierend auf dem Referenzpegel 426 erzeugt werden oder diesem entsprechen. In einem Beispiel ist der erste interne Referenzpegel 447 im Wesentlichen gleich der Emitterspannung des Leistungshalbleiterschalters. Das ist vorteilhaft, da typischerweise in Kurzschluss- und/oder Überstromzustand-Detektionsschaltungen (siehe Block 240 in **Fig. 2)** ebenfalls ein Referenzsignal repräsentativ für die Emitterspannung verwendet wird. Somit sind in diesem Fall sowohl eine Kollektor-Emitterspannungssignal als auch ein dynamisches Referenzsignal, die miteinander verglichen werden, auf dasselbe Signal referenziert. Das kann die gegenseitige Stabilisierung der Signale erleichtern. Nichtsdestoweniger ist für den ersten internen Referenzpegel 447 ($V_1$) jeder Pegel verwendbar, der unterhalb des statischen Spannungsreferenzpegels liegt.

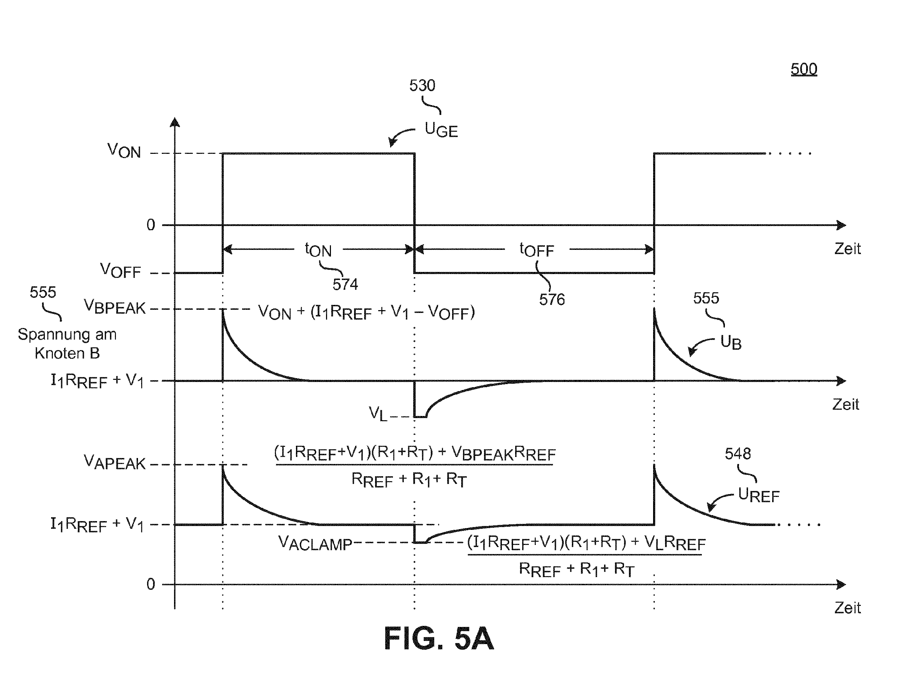

Der Knoten A des Referenzsignal-Generators 452, der mit einem Ausgang zur Ausgabe des dynamischen Referenzsignals 448 verbunden ist, wird somit von der Schaltung zum Erzeugen des stationären Signalpegels auf einen stationären Signalpegels gehoben. In Fig. 4A und den folgenden Figuren ist das dynamische Referenzsignal 448 ($U_{REF}$) ein dynamisches Spannungssignal. Allerdings kann, wie bereits mehrfach ausgeführt, auch ein dynamisches Stromsignal verwendet werden. Dieser stationären Signalpegel ist in der beispielhaften Vorrichtung gemäß **Fig. 4A** $V_1 + R_{REF}*I_1$. Wenn der Spannungspegel des Knoten A nicht von der passiven Lade-Schaltung 450 beeinflusst wird, entspricht der der Pegel des dynamischen Referenzsignals 448 dem stationären Signalpegel (also $V_1 + R_{REF}*I_1$). Dieses Verhalten ist in **Fig. 5A** dargestellt. Die unterste Kurve stellt einen beispielhaften Verlauf der Spannung am Knoten A (und somit des dynamischen Referenzsignals 548) dar. Es ist zu sehen, dass der Spannungspegel am Knoten A abgesehen von bestimmten Zeiten, die auf die Umschaltvorgänge des Halbleiterschalters folgen, stationär ist.

Mit dem Referenzsignal-Generator 452 ist die passive Ladeschaltung 450 über Widerstand 466 ($R_1$) verbunden (dieser ist in **Fig. 4A** als zum Referenzsignal-Generator 452 gehörig eingezeichnet, was jedoch eine willkürliche Einteilung ist). Die passive Ladeschaltung 450 enthält ein RC-Glied. Dieses umfasst eine Kapazität 456 ($C_T$) und einen Widerstand 460 ($R_T$). Die Kapazität 456 ist zwischen einen Knoten B und einen Eingang, der das Steuersignals des Leistungshalbleiterschalters 430 empfängt, gekoppelt. Der Widerstand 460 ist zwischen den Knoten B und den Knoten A des Referenzsignal-Generators 452 gekoppelt. Die Widerstände 460 und 466 können auch ein einzelner Widerstand sein.

Überdies enthält die passive Lade-Schaltung 450 eine optionale erste Klemmschaltung 454, die ein Spannungspegel am Knoten B auf einen zweiten internen Referenzpegel 462 ($V_L$) limitiert. Im Beispiel von **Fig. 4A** enthält die erste Klemmschaltung 454 eine Diode 454. Der zweite interne Referenzpegel 462 kann jeder Pegel sein, der kleiner oder gleich dem statischen Spannungsreferenzpegel ist. Wenn der externe Referenzpegel 426 diese Bedingung erfüllt, kann er als zweiter interner Referenzpegel 462 verwendet werden. Wiederum kann damit der zweite interne Referenzpegel 462 für die Emitterspannung des Halbleiterleistungsschalters repräsentativ sein. Die passive Lade-Schaltung 450 enthält keine aktiven Komponenten.

Die Funktion der passiven Lade-Schaltung wird erneut anhand von **Fig. 5A** erläutert. Wie bereits angesprochen, gibt die Vorrichtung zum Erzeugen eines dynamischen Referenzsignals 442 unmittelbar vor einem Umschaltvorgang eine dynamische Referenzspannung aus, die im Wesentlichen dem internen Referenzpegel 447 plus der über Widerstand $R_{REF}$ 464 von Konstantstrom 446 erzeugten Spannung entspricht ($I_1*R_{REF} + V_1$ in der Vorrichtung von **Fig. 4A).** In anderen Worten ist kurz vor einem Umschaltvorgang die dynamische Referenzspannung 448 gleich dem stationären Spannungspegel. Die oberste Kurve von **Fig. 5A** zeigt einen beispielhaften Verlauf eines Steuersignals 530 ($U_{GE}$) des Leistungshalbleiterschalters. Der Spannungspegel des Steuersignals 530 steigt von einem Pegel im ausgeschalteten Zustand $V_{OFF}$ auf einen Pegel im angeschalteten Zustand $V_{ON}$. Grundsätzlich können diese Pegel beliebig gewählt werden. In einem Beispiel entsprechen die Pegel $V_{OFF}$ und $V_{ON}$ der Gate-Emitter-Spannung des Leistungshalbleiterschalters, die den Leistungshalbleiterschalter steuert, im ausgeschalteten beziehungsweise eingeschalteten Zustand. Zum Beispiel kann ein Pegel im ausgeschalteten Zustand $V_{OFF}$ für IGBTs zwischen - 20V und -5V liegen (bevorzugt zwischen -15V und -7V) und ein Pegel im angeschalteten Zustand $V_{ON}$ kann für IGBTs zwischen 10V und 20V liegen (bevorzugt zwischen 13V und 15). Für Leistungs-MOSFETs können entsprechend die Pegel $V_{OFF}$ und $V_{ON}$ der Spannung des Gate-Source-Spannung des Leistungs-MOSFETs im ausgeschalteten beziehungsweise eingeschalteten Zustand entsprechen. Zum Beispiel kann ein Pegel im ausgeschalteten Zustand $V_{OFF}$ für Leistungs-MOSFETs zwischen -5V und 0V liegen und ein Pegel im angeschalteten Zustand $V_{ON}$ kann für MOSFETs zwischen 10V und 25V liegen. Für Bauteile auf SiC-Basis kann ein Pegel im ausgeschalteten Zustand $V_{OFF}$ ebenfalls zwischen -5V und 0V liegen und ein Pegel im angeschalteten Zustand $V_{ON}$ zwischen 10V und 20V liegen.

Wie in Fig. 5A gezeigt, steigt zum Zeitpunkt des Umschaltens von einem ausgeschalteten Zustand in einen angeschalteten Zustand des Leistungshalbleiterschalters der Spannungspegel am Knoten B und am Knoten A der Vorrichtung zum Erzeugen eines dynamischen Referenzsignals 442 sprunghaft an. Dieser Anstieg entspricht dem Spannungshub des Steuersignals 530 (Steuersignal 430 in **Fig. 4A)** beim Umschalten vom ausgeschalteten in den angeschalteten Zustand. Das kann anhand von **Fig. 4A** nachvollzogen werden: Da der Spannungshub des Steuersignal 430 den Spannungspegel an einem Ausgang der Kapazität 456 erhöht, erhöht sich auch der Spannungspegel am Knoten B um diesen Betrag (die Diode 454 ist nichtleitend, da der Pegel an Knoten B über dem Pegel der zweiten Referenzspannung liegt). Die Amplitude des Spannungssprungs entspricht also der Differenz aus dem Pegel im angeschalteten Zustand $V_{ON}$ und dem Pegel im angeschalteten Zustand $V_{OFF}$ des Steuersignals 530 (430 in **Fig. 4A).** Somit ergibt sich am Knoten B im Zeitpunkt nach dem Umschaltvorgang ein Spannungspegel $V_{Bpeak}$ von

$$V_{Bpeak} = V_{ON} + I_1 R_{REF} + V_1 - V_{OFF}. \qquad \text{(Gleichung 1)}$$

Das hat zur Folge, dass ein zusätzlicher Strom durch die Widerstände 460 ($R_T$), 466 ($R_1$) und 464 ($R_{REF}$) getrieben wird. Dieser Strom erhöht den Spannungspegel am Knoten A um einen bestimmten Betrag (nämlich der Stromstärke des zusätzlichen Stroms multipliziert mit dem Wert des Widerstands 464). Somit ergibt sich unmittelbar nach dem Einschalten des Leistungshalbleiterschalters am Knoten A eine Spannung von

$$V_{Apeak} = \frac{(I_1 R_{REF} + V_1)(R_1 + R_T) + V_{Bpeak} R_{REF}}{R_{REF} + R_1 + R_T}$$

(Gleichung 2)

Da der Ausgang zum Abgreifen des dynamischen Referenzsignals 448 direkt mit Knoten A verbunden ist, entspricht der in Fig. 5A gezeigte Spannungspegel dem dynamischen Referenzsignal 448.

Zusätzlich entlädt der zusätzliche Strom die Kapazität 456 der passiven Lade-Schaltung 450. Das hat zur Folge, dass eine Spannung über der Kapazität 454 abnimmt und folglich auch der Spannungspegel am Knoten B sinkt. Daraus wiederum folgt, dass der zusätzliche Strom abnimmt und auch die Spannung am Knoten A sinkt (und somit der Pegel des dynamischen Referenzsignals 448). Nach einer vorbestimmten Zeit hat sich die Kapazität soweit entladen, dass kein zusätzlicher Strom mehr durch den Widerstand 464 getrieben wird. Somit liegt die Spannung am Knoten A wieder bei ihrem stationären Pegel (von $I_1{}^* R_{REF} + V_1$). Die durch die passive Lade-Schaltung erzeugte zeitweise Erhöhung des dynamischen Referenzsignals ist abgeklungen.

Die Zeitkonstante des Entladevorgangs der Kapazität 456 wird durch die Werte der Widerstände 460 ($R_T$), 466 ($R_1$) und 464 ($R_{REF}$) und den Wert der Kapazität 456 ($C_T$) bestimmt. Sie und die Amplitude des Spannungshubs in dem dynamischen Referenzsignal 448 können so gewählt werden, dass fälschliche Detektionen eines ein Kurzschluss- und/oder Überstromzustands nach einem Umschaltvorgang von einem ausgeschalteten Zustand in einen angeschalteten Zustand des Leistungshalbleiterschalters verhindert oder zumindest reduziert werden und trotzdem eine Schutzfunktion erreicht wird durch ein sicheres Abschalten des Leistungshalbleiterschalters. Das kann wiederum anhand von **Fig. 6** illustriert werden. Die zeitweise Erhöhung des dynamischen Referenzsignals 648 stellt sicher, dass das Signal, das für die Kollektor-Emitterspannung repräsentativ ist im Normalfall (linke Seite in **Fig. 6**) unterhalb des dynamischen Referenzsignals liegt. Die Kurzschluss- und/oder Überstromzustand-Detektionsschaltung 240 in **Fig. 2** würde also keinen Kurzschluss- und/oder Überstromzustand detektieren.

In **Fig. 5A** ist zudem das Verhalten der Vorrichtung zum Erzeugen eines dynamischen Referenzsignals 442 nach einem Umschaltvorgang von einem angeschalteten Zustand in einen ausgeschalteten Zustand des Leistungshalbleiterschalters gezeigt. Hier ereignet sich der umgekehrte Prozess wie im Falle des Umschaltvorgangs vom ausgeschalteten Zustand in einen angeschalteten Zustand, der weiter oben beschrieben wurde. Erneut liegt ein, in diesem Fall negative, Spannungshub des Steuersignals 530 an dem ersten Eingang der Kapazität 454 an und verringert die Spannung am Knoten B. Dies hat wiederum einen zusätzlichen Strom zur Folge, der die Spannung am Knoten A reduziert. Im Gegensatz zu dem Anschaltvorgang ist nun jedoch die erste Klemmschaltung 454aktiv und begrenzt den Spannungsabfall am Knoten B auf den zweiten internen Referenzpegel $V_L$. Wie bereits erwähnt ist die erste Klemmschaltung 454optional, die Vorrichtung zum Erzeugen eines dynamischen Referenzsignals 442 kann auch ohne sie verwendet werden. Dann würde das dynamische Referenzsignal 448 um den vollen Spannungshub des Steuersignals 430 verringert werden. Das kann jedoch nachteilig sein, da unter Umständen die Spannung am Knoten A (das dynamische Referenzsignal 448) und die Spannung am Knoten B nicht genug Zeit haben, auf den stationären Signalpegel zurückzukehren.

Der durch die erste Klemmschaltung nach unten begrenzte Spannungshub am Knoten A ergibt sich somit zu:

$$V_{Aclamp} = \frac{(I_1 R_{REF} + V_1)(R_1 + R_T) + V_L R_{REF}}{R_{REF} + R_1 + R_T}$$

(Gleichung 3)

Analog zu der oben beschriebenen Situation führt der zusätzliche Strom nun dazu, dass sich die Kapazität 456 lädt. Zum Abschluss dieses Ladevorgangs entspricht die Spannung 458 über der Kapazität 456 wieder der Spannung vor Beginn des Umschaltvorgangs, der zusätzliche Strom hört auf zu fließen und die dynamische Referenzspannung 548 hat wieder ihren stationären Signalpegel ($I_1$*$R_{REF}$ + $V_1$). **Fig. 4B** zeigt ein zweites Beispiel einer Vorrichtung zum Erzeugen eines dynamischen Referenzsignals. Der Aufbau entspricht der der in **Fig. 4A** gezeigten Vorrichtung, in der zusätzlich eine zweite Klemmschaltung 468, 470 vorgesehen ist. Diese ist dazu ausgelegt, die dynamische Referenzspannung 448 auf einen vorbestimmten Maximalwert zu begrenzen. In **Fig. 4B** wird der Maximalwert der dynamischen Referenzspannung 448 durch einen dritten internen Referenzpegel $V_H$ festgelegt. Da die zweite Klemmschaltung 468, 470 zwischen den Widerständen 460 und 466 gekoppelt ist, wird der Maximalwert der Spannung $V_{apeak}$ am Knoten A auf

$$V_{Apeak} = \frac{(I_1 R_{REF} + V_1)R_1 + V_H R_{REF}}{R_{REF} + R_1} \qquad \text{(Gleichung 4)}$$

geklemmt. Um die Darstellung nicht unnötig zu verkomplizieren wurde für die hier diskutierten Gleichungen ein Spannungsabfall über den Dioden von Null angenommen, wenn die Dioden in Vorwärtsrichtung gepolt sind. Die zweite Klemmschaltung 468, 470 kann eine zweite Diode 468 enthalten. Der dritte interne Referenzpegel $V_H$ wird gewählt, um Schaden an Bauelementen, mit denen die Vorrichtung 442 zum Erzeugen eines dynamischen Referenzsignals verbunden ist, zu verhindern. Beispielsweise kann, wie in **Fig. 2** gezeigt, der Konstantstrom $I_1$ von der Treiberschaltung 236 geliefert werden. Da das dynamische Referenzsignal 448 an dem Referenzausgang der Treiberschaltung 236 anliegt, kann diese durch den erhöhten Spannungspegel des dynamischen Referenzsignals 448 Schaden nehmen. Zum Beispiel kann die maximal zulässige Spannung am Referenzausgang der Treiberschaltung 236 $V_{ON}$ entsprechen. In anderen Umgebungen kann die maximal zulässige Spannung auch höher sein, weswegen eine Begrenzung mittels der zweiten Klemmschaltung 468 nicht unbedingt notwendig ist.

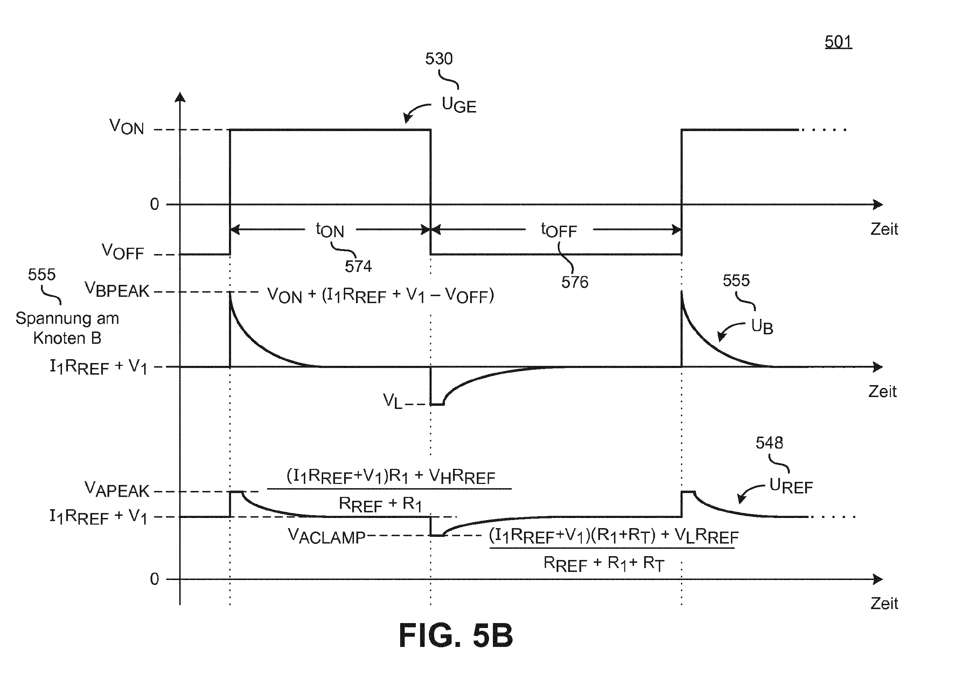

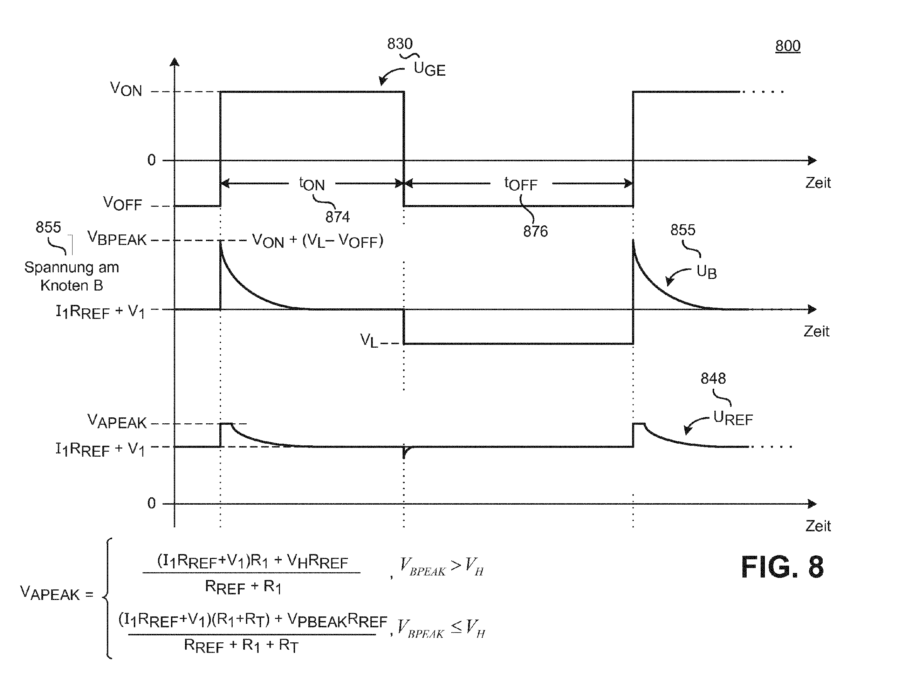

Der Verlauf des zeitweise erhöhten dynamischen Referenzsignals 448 in der Vorrichtung gemäß **Fig. 4B** ist in **Fig. 5B** skizziert. Hier ist zu sehen, dass der Verlauf des Spannungspegels am Knoten B in den Vorrichtungen gemäß **Fig. 4A** und **Fig. 4B** identisch sind. Auch der Verlauf der zeitweisen Reduzierung des dynamischen Referenzsignals 548 unter seinen stationären Pegel entspricht dem in **Fig. 5A** skizzierten. Ein Unterschied ist beim Umschaltvorgang von einem ausgeschalteten Zustand in einen angeschalteten Zustand des Leistungshalbleiterschalters zu sehen. Hier wird das dynamische Referenzsignal zunächst auf den in Gleichung 4 gegebenen Wert geklemmt bis die Diode 468 der zweiten Klemmschaltung aufhört zu leiten. Im Anschluss daran fällt die dynamische Referenzspannung 548 wieder auf ihren stationären Signalpegel ab. In **Fig. 7** ist ein drittes Beispiel für eine Vorrichtung zum Erzeugen eines dynamischen Referenzsignals 742. Die Vorrichtung entspricht der in **Fig. 4B** gezeigten Vorrichtung 442, mit der Ausnahme, dass eine dritte Diode 772 ($D_3$) zwischen der zweiten Klemmschaltung 768, 570 und dem Widerstand 760 ($R_T$) angeordnet ist. Die dritte Diode 772 ($D_3$) beeinflusst das Verhalten der Vorrichtung zum Erzeugen eines dynamischen Referenzsignals 742 nach einem Umschaltvorgang des Leistungshalbleiterschalters von einem eingeschalteten in einen ausgeschalteten Zustand. Wie in **Fig. 8** zu sehen, entsprechen die Verläufe der Spannungspegel an den Knoten A (entsprechend der dynamischen Referenzsignal 848) und dem Spannungspegel am Knoten B 855 nach dem Anschaltvorgang denen in **Fig. 5B** gezeigten. Nach einem Umschaltvorgang von einem angeschalteten zu einem ausgeschalteten Zustand des Leistungshalbleiterschalters unterscheidet sich das Verhalten der Vorrichtungen zum Erzeugen eines dynamischen Referenzsignals gemäß **Fig. 4B** und **Fig. 8** jedoch.

Wenn der negative Spannungshub des Steuersignals 830 den Spannungspegel an Knoten B senkt (wiederum limitiert durch die erste Klemmschaltung 754 auf den Spannungspegel $V_L$), sperrt die Diode 772 ($D_3$). Damit wird der Referenzsignal-Generator 752 von der passiven Lade-Schaltung 752 entkoppelt. Das hat wiederum zur Folge, dass ein Fallen des Spannungspegels am Knoten A unter den stationären Spannungspegel (und folglich auch des dynamischen Referenzsignals 748) verhindert oder erheblich verringert werden kann. Der Spannungspegel am Knoten A kehrt sehr schnell auf seinen statischen Pegel ($V_1$ + $I_1$*$R_{REF}$) zurück, da dieser Prozess nicht mehr an das Entladeverhalten der Kapazität 756 des RC-Glieds der passiven Lade-Schaltung 750 gekoppelt ist. Die Spannung $U_{CT}$ über der Kapazität 756 ($C_T$) beträgt nach dem Wechsel vom AUS- in den AN-Zustand statisch $U_{CT}=(I_1$*$R_{REF}+V_1)-V_{ON}$. Die Kapazität wird auf diesen Wert entladen über $R_T$, $R_1$ und $R_{REF}$, was zur dynamischen Erhöhung von der dynamischen Referenzspannung $U_{REF}$ führt. Beim Wechsel vom An- in den Auszustand wird die Kapazität 756 ($C_T$) über die erste Klemmschaltung 754 ohne wesentliche Verzögerung (es ist kein Widerstand am Laden beteiligt die Diode D1 wird dabei vernachlässigt) auf den Wert $U_{CT}=V_L-V_{OFF}$ nachgeladen. Da der zweite interne Referenzpegel 762 (VL) tiefer liegt als $I_1$*$R_{REF}+V_1$, sperrt die Diode 772 (D3). Somit wird die die Kapazität 756 ($C_T$) über diesen Pfad nicht zusätzlich nachgeladen. Dieses Verhalten ist in Kurve 848 in **Fig. 8** dargestellt, die den zeitlichen Verlauf des dynamischen Referenzsignals in der Vorrichtung gemäß **Fig. 8** zeigt.

Eine Unterdrückung oder Verringerung des negativen Ausschlags (unter den stationären Spannungspegel) ist vorteilhaft, da der negative Ausschlag des dynamischen Referenzsignals 748 zum Beispiel im Falle kurzer Aus-Perioden 876 ($t_{OFF}$) zur Folge haben kann, dass das dynamische Referenzsignal 848 noch nicht wieder auf seinen statischen Wert zurückgekehrt ist, wenn ein folgender Anschaltvorgang stattfindet. Das kann zur Folge haben, dass das dynamische Referenzsignal $U_{REF}$ beim Einschalten (siehe **Fig. 6** links unten) im dynamischen "gestaucht" wird (d. h. der Spitzenwert des dynamischen Referenzsignals $U_{REF}$ liegt tiefer als bei längeren Aus-Perioden 876). Das wiederum kann unter Umständen dazu führen, dass das für die Kollektor-Emitter-Spannung repräsentative Signal $U_{C'E}$ den Verlauf des dynamische Referenzsignals $U_{REF}$ selbst beim normalen Einschalten kreuzen kann. Dann meldet die Überstromzustand-Detektionsschaltung 240 einen Überstrom- oder Kurzschlusszustand an die Treiberschaltung 236, obschon nichts dergleichen aufgetreten ist.

Die obige Beschreibung der dargestellten Beispiele der vorliegenden Erfindung, ist nicht erschöpfend oder beschränkt auf die Beispiele gemeint. Während spezifische Ausführungsformen und Beispiele für die Erfindung hierin zu Veranschaulichungszwecken beschrieben sind, sind verschiedene Modifikationen möglich, ohne von der vorliegenden Erfindung abzuweichen. Die spezifischen Beispiele für Spannung, Strom, Frequenz, Leistung, Bereichswerte, Zeiten etc., sind nur illustrativ, so dass die vorliegende Erfindung auch mit anderen Werten für diese Größen umgesetzt werden kann.

Diese Modifikationen können an Beispielen der Erfindung im Lichte der obigen detaillierten Beschreibung durchgeführt werden. Die Begriffe, die in den folgenden Ansprüchen verwendet werden, sollten nicht so ausgelegt werden, als dass die Erfindung auf die spezifischen Ausführungsformen, die in der Beschreibung und den Ansprüchen offenbart sind, beschränkt ist. Die vorliegende Beschreibung und die Figuren sind als veranschaulichend und nicht als einschränkend anzusehen.

**Patentansprüche**

1.  Vorrichtung zum Erzeugen eines dynamischen Referenzsignals für eine Steuerschaltung für einen Leistungshalbleiterschalter, wobei die Vorrichtung umfasst:

    - einen Referenzsignal-Generator zur Bereitstellung eines dynamischen Referenzsignals, das nach Verstreichen einer vorbestimmten Zeit nach einem Umschaltvorgang des Leistungshalbleiterschalters einen stationären Signalpegel hat;
    - eine passive Lade-Schaltung, die ausgelegt ist, um einen Signalpegel des dynamischen Referenzsignals in Reaktion auf ein Umschalten eines Steuersignals des Leistungshalbleiterschalters von einem AUS-Zustand in einen AN-Zustand für mindestens einen Teil der vorbestimmte Zeit über den stationären Signalpegel zu erhöhen zur Erzeugung des dynamischen Referenzsignals; und
    - einen Ausgang zum Abgreifen des dynamischen Referenzsignals.

2.  Vorrichtung gemäß Anspruch 1, wobei das dynamische Referenzsignal eine dynamische Referenzspannung ist.

3.  Vorrichtung gemäß einem der vorangehenden Ansprüche, wobei die passive Lade-Schaltung ein RC-Glied umfasst.

4.  Vorrichtung gemäß einem der vorangehenden Ansprüche, wobei passive Lade-Schaltung dazu ausgelegt ist, den Signalpegel des dynamischen Referenzsignals in Reaktion auf das Umschalten des Steuersignals sprungförmig zu erhöhen.

5.  Vorrichtung gemäß Anspruch 3 oder 4, wobei die passive Lade-Schaltung weiter ausgelegt ist, so dass sich die Kapazität des RC-Gliedes im Anschluss an ein Umschalten eines Steuersignals des Leistungshalbleiterschalters von einem AN-Zustand in einen AUS-Zustand lädt.

6.  Vorrichtung gemäß einem der Ansprüche 3 bis 5, wobei die passive Lade-Schaltung so ausgelegt ist, dass sich die Kapazität des RC-Gliedes im Anschluss an das Umschalten des Steuersignals entlädt und damit den zweitweise erhöhten Pegel des dynamischen Referenzsignals erzeugt und durch die Entladung wieder auf den stationären Pegel zurückzuführt.

7.  Vorrichtung gemäß einem der vorangehenden Ansprüche, wobei der Referenzsignal-Generator eine Schaltung zum Erzeugen des stationären Signalpegels enthält.

8.  Vorrichtung gemäß einem der vorangehenden Ansprüche, weiter umfassend:

    eine erste Klemmschaltung, die dazu ausgelegt ist, das dynamische Referenzsignal auf einen vorbestimmten Minimalpegel zu begrenzen.

9. Vorrichtung gemäß einem der vorangehenden Ansprüche, weiter umfassend:

eine zweite Klemmschaltung, die dazu ausgelegt ist, das dynamische Referenzsignal auf einen vorbestimmten Maximalpegel zu beschränken.

10. Vorrichtung gemäß einem der vorangehenden Ansprüche, weiter umfassend:

einen passiven Schalter, der zwischen den Referenzsignal-Generator und die passive Lade-Schaltung gekoppelt ist, wobei der passive Schalter dazu ausgelegt ist, den Referenzsignal-Generator und die passive Lade-Schaltung zu trennen in Reaktion auf ein Umschalten des Steuersignals des Leistungshalbleiterschalters von einem AN-Zustand in einen AUS-Zustand.

11. Vorrichtung gemäß einem der vorangehenden Ansprüche, wobei das dynamische Referenzsignal ein Stromsignal ist.

12. Vorrichtung gemäß einem der vorangehenden Ansprüche, wobei die Schaltung zum Erzeugen eines dynamischen Referenzsignals einen Eingang zum Koppeln an einen externen statischen Referenzpegel und wobei die Schaltung zum Erzeugen eines dynamischen Referenzsignals dazu ausgelegt ist, den statischen Referenzpegel direkt oder in umgewandelter Form als stationären Signalpegel zu verwenden.

13. Vorrichtung gemäß einem der vorangehenden Ansprüche, wobei ein interner Referenzpegel der Vorrichtung den stationären Signalpegel bildet.

14. Vorrichtung gemäß einem der Ansprüche 3 bis 13, wobei sich die Kapazität des RC-Gliedes mit einer Zeitkonstante entlädt, die ausgewählt ist, um zu verhindern , dass die Kurzschluss- und/oder Überstromzustand-Detektionsschaltung im Normalbetrieb einen Kurzschluss- und/oder Überstromzustand detektiert.

15. Vorrichtung gemäß einem der Ansprüche 3 bis 13, wobei sich die Kapazität des RC-Gliedes mit einer Zeitkonstante entlädt, die ausgewählt ist, um sicherzustellen, dass die Kurzschluss- und/oder Überstromzustand-Detektionsschaltung im Kurzschluss- und/oder Überstromfall einen Kurzschluss- und/oder Überstromzustand detektiert.

FIG. 1

EP 2 955 849 A1

**FIG. 2**

EP 2 955 849 A1

FIG. 3

FIG. 4A

**FIG. 4B**

EP 2 955 849 A1

**FIG. 5A**

FIG. 5B

**FIG. 6**

EP 2 955 849 A1

**FIG. 7**

EP 2 955 849 A1

FIG. 8

$$V_{APEAK} = \begin{cases} \dfrac{(I_1 R_{REF} + V_1)R_1 + V_H R_{REF}}{R_{REF} + R_1} & , V_{BPEAK} > V_H \\[4mm] \dfrac{(I_1 R_{REF} + V_1)(R_1 + R_T) + V_{PBEAK} R_{REF}}{R_{REF} + R_1 + R_T} & , V_{BPEAK} \le V_H \end{cases}$$

EP 2 955 849 A1

**Europäisches Patentamt**
**European Patent Office**
**Office européen des brevets**

## EUROPÄISCHER RECHERCHENBERICHT

Nummer der Anmeldung

EP 14 17 2012

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 5 453 669 A (NISHIBE YASUSHI [JP] ET AL) 26. September 1995 (1995-09-26) * Abbildungen 3,4A,4B * ----- | 1-15 | INV. H03K17/16 H03K17/082 |
| | | | RECHERCHIERTE SACHGEBIETE (IPC) H03K |

Der vorliegende Recherchenbericht wurde für alle Patentansprüche erstellt

| Recherchenort | Abschlußdatum der Recherche | Prüfer |
|---|---|---|
| Den Haag | 11. Dezember 2014 | Simon, Volker |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 14 17 2012

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-12-2014

| Im Recherchenbericht angeführtes Patentdokument | Datum der Veröffentlichung | Mitglied(er) der Patentfamilie | Datum der Veröffentlichung |
|---|---|---|---|
| US 5453669 A | 26-09-1995 | JP H0759376 A<br>US 5453669 A | 03-03-1995<br>26-09-1995 |

Für nähere Einzelheiten zu diesem Anhang : siehe Amtsblatt des Europäischen Patentamts, Nr.12/82